# EUROPEAN PATENT APPLICATION

(11) **EP 4 819 495 A1**
(43) Date of publication of application: **07.10.2026**
(21) Application number: 24902994.3
(22) Date of filing: 13.12.2024
(51) Int. Cl.: H03M 13/11

(54) **COMMUNICATION METHOD AND RELATED APPARATUS**

(30) Priority: 15.12.2023 CN 202311739096
(71) Applicant: Huawei Technologies Co., Ltd., Shenzhen, Guangdong 518129 (CN)
(72) Inventor: HAN, Chengcheng, Shenzhen, Guangdong 518129 (CN); GUO, Zhiheng, Shenzhen, Guangdong 518129 (CN); XIE, Xinqian, Shenzhen, Guangdong 518129 (CN)
(74) Representative: Goddar, Heinz J.
(86) International application number: PCT/CN2024/139373
(87) International publication number: WO 2025/124579

(57) **Abstract**

This application provides a communication method apparatus, so as to improve decoding performance. The method includes: obtaining a check matrix of the target SC-LDPC code, where a quantity of rows in the check matrix is M, a quantity of columns is N, and a value of an element is 0 or 1; and the check matrix of the target SC-LDPC code includes a second matrix that includes an ith row to an (i+(Z+1)*m-1)th row in M rows and a 0th column to an (n-1)th column in N columns. The second matrix is obtained by arranging (Z+1) third matrices with m rows and n columns in sequence according to rows, and Z third matrices exist in the (Z+1) third matrices. A quantity of elements 1 included in the Z third matrices K and a quantity of elements 1 included in the second matrix L satisfy the following relationship: K/L=Z*z%; encoding the information bits based on the check matrix of the target SC-LDPC code, to obtain the first SC-LDPC codeword.

## Description

This application claims priority to Chinese Patent Application No. 202311739096.9, filed with the State Intellectual Property Office of China on December 15, 2023, and entitled "Communication Method and Related Apparatus." The entire content of this application is incorporated herein by reference.

### TECHNICAL FIELD

This application relates to the field of communications technologies, and in particular, to a communication method and a related apparatus.

### BACKGROUND

Low-density parity check (LDPC) codes are a type of linear block code with a sparse parity check matrix. LDPC codes not only exhibit excellent performance that approaches the Shannon limit, but also feature low decoding complexity, flexible structure, and have become a research hotspot in the field of channel coding in recent years. Quasi-cyclic low-density parity check (QC-LDPC) codes, as a class of structured LDPC codes, have been well applied in certain communication systems due to their advantages of simple description, easy construction, and saving storage space. For example, in the 5th generation (5th generation, 5G) communication system, the new radio access technology (new radio access technology, NR) has been effectively utilized.

However, at present, the QC-LDPC code in the 5G-NR standard has an error floor, and the parallelism of decoding is also limited. As a result, the QC-LDPC code exhibits relatively low decoding performance during actual application, making it difficult to meet the encoding and decoding requirements of future communication systems for high-reliability and high-throughput services.

### SUMMARY

This application provides a communication method and a related apparatus, to improve decoding performance.

According to a first aspect, this application provides a communication method, and the method may be applied to a first communication apparatus. For example, the first communication apparatus may be a terminal device or a network device, or may be a component (such as a chip or a chip system) configured in the terminal device or the network device, or may be a logical module or software that can implement all or some functions of the terminal device or the network device. This is not limited in this application.

For example, the method includes: obtaining a check matrix of a target spatially coupled low-density parity check (spatially coupled LDPC, SC-LDPC) code, where the check matrix of the target SC-LDPC code is obtained from a preset check matrix of the SC-LDPC code based on a target code rate and a length of an information bit; and; encoding the information bits based on the check matrix of the target SC-LDPC code, to obtain the first SC-LDPC codeword.

Example 1: The check matrix of the target SC-LDPC code is a portion extracted from the check matrix of the preset SC-LDPC code, based on the target code rate and the length of the information bits.

Wherein, the number of rows in the check matrix of the preset SC-LDPC code is M, and the number of columns is N. The value of the elements in the check matrix of the preset SC-LDPC code is 0 or 1, or, the number of rows in the check matrix of the target SC-LDPC code is M, and the number of columns is N. The value of the elements in the check matrix of the target SC-LDPC code is 0 or 1.

Example 2: The check matrix of the preset SC-LDPC code is included in the first mapping relationship. This mapping relationship indicates at least one code rate, at least one length of information bits, and a correspondence between at least one check matrix of the preset SC-LDPC code. That is, the check matrix of the target SC-LDPC code is determined based on the target code rate, the length of the information bits, and the first mapping relationship.

A quantity of rows and columns in the check matrix of the target SC-LDPC code are M, and a value of an element in the check matrix of the target SC-LDPC code is 0 or 1.

With reference to Example 1 and Example 2, a 0th row to a (M-1)th row in the M rows, the first matrix formed by the 0th column to the (n-1)th column in the N columns comprises a second matrix whose row quantity is ((Z+1)*m) and a column quantity is n, wherein elements in the jth column to the (j+n-1)th column in the N columns are obtained by cyclically shifting ((j/n)*m) rows downwards in the first matrix; and; the second matrix is a matrix formed by an ith row to an (i+(Z+1)*m-1)th row in the first matrix, and all other elements in the first matrix except the second matrix are 0; and the second matrix is obtained by arranging (Z+1) third matrices with m rows and n columns in sequence according to rows, and Z third matrices exist in the (Z+1) third matrices, a quantity K of elements 1 comprised in the Z third matrices and a quantity L of elements 1 comprised in the second matrix satisfy the following relationship: K/L=Z*z%, K/L≤50%, (L-K) ≥ (K/Z), or a quantity of remaining elements 1 in the second matrix except the K elements 1 included in the Z third matrices is greater than or equal to a quantity of elements 1 included in at least one of the Z third matrices.

Z is an integer greater than 0, z is an integer less than or equal to 100*R, or z is an integer less than or equal to 100*(1-R), and R is a target code rate or a maximum code rate that can be supported by a preset check matrix of the SC-LDPC code. or a minimum code rate, where i is an integer greater than or equal to 0 and less than or equal to (M - (Z+1)*m), and j=n, 2*n, ..., y*n; and; (y+1)=N/n, where M can be divisible by m, and n, m, and y are integers greater than 1.

Based on the method, the first communication apparatus (an encoding apparatus) encodes the information bits by using the obtained check matrix of the target SC-LDPC code, to obtain the first SC-LDPC codeword. The second communication apparatus (a decoding apparatus) also decodes the first SC-LDPC codeword by using the check matrix of the target SC-LDPC code. Because a coupling feature exists between a plurality of second matrices included in the check matrix of the target SC-LDPC code, Therefore, relatively good bit error performance can be obtained. In addition, the check matrix of the target SC-LDPC code increases a degree of decoding parallelism, fast decoding can be implemented, and relatively good decoding performance can be obtained.

With reference to the first aspect, in some implementations of the first aspect, the first SC-LDPC codeword includes Q groups of encoded bits, and each group of encoded bits in the Q groups of encoded bits includes a group of information bits and a group of check bits, where the Q groups of information bits each include A information bits, and each group of check bits in the Q groups of check bits includes B check bits. A and B are integers greater than 0, and Q=N/n.

With reference to the first aspect, in some possible implementations of the first aspect, the method further comprises: reordering the Q groups of encoded bits included in the first SC-LDPC codeword, to obtain a second SC-LDPC codeword; interleaving and modulating the second SC-LDPC codeword to obtain a plurality of modulation symbols; and sending the plurality of modulation symbols.

Wherein, the Q groups of information bits and the Q groups of check bits included in the second SC-LDPC codeword meet any one of the following characteristics:
the Q groups of information bits are located before the Q groups of check bits;
q groups of coded bits that are used as a decoding start point in the Q groups of coded bits are located before other groups of coded bits;
q groups of coded bits that are used as a decoding start point in the Q groups of coded bits are located before another group of coded bits, and an information bit in each group of coded bits is located before a check bit; or,
q groups of coded bits in the Q groups of coded bits that serve as a decoding start point are located before another group of coded bits, information bits in the q groups of coded bits are located before check bits in the q groups of coded bits, and q is an integer greater than 0 and less than or equal to Q.

For example, locations of the other groups of coded bits in the second SC-LDPC codeword are arranged in ascending order of the first distance. the first distance is a quantity of coded bit groups between each of the other groups of coded bits and the q groups of coded bits in the first SC-LDPC codeword.

For example, the information bits in the other groups of coded bits are located before the check bits in the other groups of coded bits.

Optionally, the reordering of the Q groups of encoded bits to obtain a second SC-LDPC codeword includes: performing interleaving processing on the first SC-LDPC codeword by using a first row-column interleaver, thereby obtaining the second SC-LDPC codeword. The first row-column interleaver has Q rows and (A+B) columns.

Wherein, interleaving refers to the process in which the first SC-LDPC codeword is input row by row into the first row-column interleaver, and then read column by column to obtain the first SC-LDPC codeword.

Optionally, the reordering of the Q groups of encoded bits to obtain a second SC-LDPC codeword includes: based on the decoding manner of the first SC-LDPC codeword, reordering the Q groups of encoded bits to obtain the second SC-LDPC codeword.

Example 1: The decoding manner is bidirectional sliding window decoding, and the q groups of encoded bits are the first group of encoded bits and the Qth group of encoded bits in the first SC-LDPC codeword.

Example 2: The decoding mode is parallel sliding window decoding, q is an integer greater than 2 and less than or equal to Q, and the q groups of bits are encoded bit groups that are in the Q groups of bits and that are used as a decoding start point.

It may be understood that the foregoing decoding mode may be indicated by the second communication apparatus (for example, a decoding apparatus) to the first communication apparatus.

Optionally, the interleaving and modulating the second SC-LDPC codeword to obtain multiple modulation symbols includes: performing interleaving processing on the second SC-LDPC codeword by using a second row-column interleaver to obtain a third SC-LDPC codeword, where a quantity of rows and columns of the second row-column interleaver is P, a quantity of columns is D, D=ceil((A+B)*Q/P), and P is a modulation order; and; mapping P consecutive bits in the third SC-LDPC codeword sequentially to one modulation symbol, to obtain multiple modulation symbols, where ceil() indicates rounding up.

According to a second aspect, this application provides a communication method, and the method may be applied to a second communication apparatus. For example, the second communication apparatus may be a terminal device or a network device, or may be a component (such as a chip or a chip system) configured in the terminal device or the network device, or may be a logical module or software that can implement all or some functions of the terminal device or the network device. This is not limited in this application.

For example, the method includes: receiving multiple modulation symbols; demodulating and processing the multiple modulation symbols to obtain a first SC-LDPC codeword; obtaining a check matrix of a target SC-LDPC code, wherein the check matrix of the target SC-LDPC code is obtained from the check matrix of the preset SC-LDPC code based on the target code rate and the length of the information bit; and decoding the first SC-LDPC codeword based on the check matrix of the target SC-LDPC code, to obtain the information bit.

As for the description of the check matrix of the target SC-LDPC code and the check matrix of the preset SC-LDPC code, refer to the description of the first aspect in the foregoing text. Details are not described herein again.

Based on this method, the first communication apparatus (for example, a decoding apparatus) demodulates and processes the received modulation symbols, to obtain a first SC-LDPC codeword, and uses the check matrix of the target SC-LDPC code on the side of the first communication apparatus, which is obtained by encoding the information bit, to decode the first SC-LDPC codeword. Since the multiple second matrices in the check matrix of the target SC-LDPC code obtained by the first communication apparatus and the second communication apparatus have a coupling feature, therefore, a relatively good bit error performance can be obtained. In addition, the check matrix of the target SC-LDPC code increases the parallelism of decoding, and fast decoding can be implemented, thereby obtaining relatively good decoding performance.

With reference to the second aspect, in some possible implementations of the second aspect, the demodulating and processing the plurality of modulation symbols to obtain a first SC-LDPC codeword includes: demodulating the plurality of modulation symbols to obtain a third SC-LDPC codeword, wherein the third SC-LDPC codeword comprises (Q*A) information bits and (Q*B) check bits; and performing de-interleaving processing on the third SC-LDPC codeword to obtain a second SC-LDPC codeword, wherein the second SC-LDPC codeword comprises Q groups of encoded bits, the Q groups of encoded bits comprise a group of information bits and a group of check bits in each group of encoded bits, wherein A and B are integers greater than 0, and Q=N/n; and reordering the Q groups of information bits and the Q groups of check bits in the second SC-LDPC codeword to obtain the first SC-LDPC codeword, wherein the first SC-LDPC codeword comprises Q groups of encoded bits, the Q groups of encoded bits comprise a group of information bits and a group of check bits in each group of encoded bits.

Wherein, de-interleaving is the reverse process of interleaving. For example, using a second row-column interleaver, the third SC-LDPC codeword is de-interleaved to obtain the second SC-LDPC codeword. The number of rows in the second row-column interleaver is P, and the number of columns is D, where D = ceil((A + B) * Q / P)), and P is the modulation order. De-interleaving the third SC-LDPC codeword refers to the process of inputting the third SC-LDPC codeword into the second row-column interleaver by column and then reading out the second SC-LDPC codeword by row.

With reference to the second aspect, in some possible implementations of the second aspect, the reordering the Q groups of information bits and the Q groups of check bits in the second SC-LDPC codeword, to obtain the first SC-LDPC codeword, includes: using a first row-column interleaver to perform de-interleaving processing on the second SC-LDPC codeword, to obtain the first SC-LDPC codeword, wherein the number of rows in the first row-column interleaver is Q, and the number of columns is (A+B).

It can be understood that the aforementioned sorting method may be as follows: the first communication apparatus (for example, an encoding apparatus) indicates to the second communication apparatus.

With reference to the first and second aspects, in some implementations, the K elements 1 included in the fourth matrix are uniformly distributed in the L elements 1 included in the fifth matrix, the fourth matrix is a sum of the Z third matrices, and the fifth matrix is a sum of the (Z+1) third matrices.

In other words, the K elements 1 included in the fourth matrix are uniformly selected (or equally spaced selected) from the L elements 1 included in the fifth matrix.

Optionally, the K elements 1 included in the fourth matrix may be randomly selected from the L elements 1.

Optionally, the K elements 1 included in the fourth matrix may be randomly selected from the L elements 1.

For example, the fifth matrix includes at least K' elements 1 with different quantities of rows and different quantities of columns, the fourth matrix includes the at least K' elements 1 with different quantities of rows and different quantities of columns, and K' is an integer greater than 0 and less than K.

With reference to the first aspect and the second aspect, in some implementations, the element 1 included in each of the Z third matrices is evenly distributed in the K elements 1 included in the fourth matrix.

In other words, the element 1 included in each of the Z third matrices is evenly selected (or selected at equal intervals) from the L elements 1 included in the fourth matrix.

Optionally, the element 1 included in each of the Z third matrices is randomly selected from the L elements 1 included in the fourth matrix, and locations of the elements 1 included in any two third matrices are different in the fourth matrix.

According to a third aspect, this application provides a communication apparatus, including a module or a unit configured to implement the method in any one of the foregoing aspects and the possible implementations of any one of the foregoing aspects. It should be understood that each module or unit may implement a corresponding function by executing a computer program.

Fourth aspect. This application provides a communication apparatus, including a processor. The processor is configured to perform the method described in any one of the foregoing aspects and any one of the possible implementations of any one of the foregoing aspects.

The apparatus may further include a memory, configured to store instructions and data. The memory is coupled to the processor. When the processor executes the instructions stored in the memory, the method described in any one of the foregoing aspects can be implemented.

The apparatus may further include a communications interface, configured to enable the apparatus to communicate with another device. For example, the communications interface may be a transceiver, a circuit, a bus, a module, or another type of communications interface.

Fifth aspect. This application provides a chip system. The chip system includes at least one processor, configured to support implementation of the functions involved in any one of the foregoing aspects and any one of the possible implementations of any one of the foregoing aspects. For example, the processor may receive or process the data and/or information involved in the method.

In a possible design, the chip system further includes a memory. The memory is configured to store program instructions and data. The memory is located inside or outside the processor.

The chip system may be composed of a chip, or may include the chip and other discrete components.

According to the sixth aspect, this application provides a computer-readable storage medium, including a computer program. When the computer program is run on a computer, the computer is enabled to implement the method in any one of the foregoing aspects and any one of the possible implementations in the foregoing aspect.

According to the seventh aspect, this application provides a computer program product, where the computer program product includes: a computer program (which may also be referred to as code or an instruction). When the computer program is run, the computer is enabled to perform the method in any one of the foregoing aspects and any one of the possible implementations in the foregoing aspect.

According to the eighth aspect, this application provides a communications system, including the foregoing first communication apparatus and second communication apparatus. The first communication apparatus is configured to perform the method in any one of the foregoing aspects and any one of the possible implementations in the foregoing aspect. The second communication apparatus is configured to perform the method in any one of the foregoing aspects and any one of the possible implementations in the foregoing aspect.

It should be understood that the third aspect to the eighth aspect of this application correspond to the technical solutions of the first aspect or the second aspect of this application. The beneficial effects achieved by the various aspects and corresponding feasible implementations are similar, and details are not described again.

### BRIEF DESCRIPTION OF DRAWINGS

FIG. 1 is a schematic architectural diagram of a communications system applicable to the method provided in the embodiments of this application;
FIG. 2 is a schematic diagram of signal processing according to an embodiment of this application;
FIG. 3 is a schematic flowchart of a communication method according to an embodiment of this application.
FIG. 4 to FIG. 6 are schematic diagrams illustrating a manner of selecting K elements 1 according to an embodiment of this application;
FIG. 7 to FIG. 9 are schematic diagrams illustrating a connection relationship between multiple variable nodes and multiple check nodes according to an embodiment of this application;
FIG. 10 is a schematic diagram illustrating a first SC-LDPC codeword according to an embodiment of this application;
FIG. 11 is a schematic diagram illustrating a process of interleaving according to an embodiment of this application;
FIG. 12 is a schematic diagram illustrating a manner of determining a third SC-LDPC codeword according to an embodiment of this application.
FIG. 13 and FIG. 14 are schematic block diagrams of apparatuses according to embodiments of this application.

### DESCRIPTION OF EMBODIMENTS

The following describes the technical solutions in this application with reference to the accompanying drawings.

To facilitate understanding of the embodiments of this application, the following first provides several descriptions:

First, in the embodiments of this application, the use of prefixes such as "first" and "second" is merely for the purpose of distinguishing and describing different things that belong to the same name category. It does not impose any constraints on the order, size, or quantity of the things. For example, "a first communication apparatus" and "a second communication apparatus" are merely different devices, and do not limit the quantity of the devices or the priority relationship between the devices. For another example, "a first SC-LDPC codeword" and "a second SC-LDPC codeword" are merely different codewords, and there is no size relationship or priority relationship between the two.

Second, in the embodiments of this application, "sending" and "receiving" indicate the direction of signal transmission. For example, "sending a plurality of modulation symbols to a second communication apparatus" may be understood as that the destination end of the plurality of modulation symbols is the second communication apparatus. This may include directly sending the plurality of modulation symbols to the second communication apparatus through an air interface, and may also include indirectly sending the plurality of modulation symbols to the second communication apparatus through an air interface by using another unit or module. "Receiving a plurality of modulation symbols from a first communication apparatus" may be understood as that the source end of the plurality of modulation symbols is the first communication apparatus. This may include directly receiving the plurality of modulation symbols from the first communication apparatus through an air interface, and may also include indirectly receiving the plurality of modulation symbols from the first communication apparatus through an air interface by using another unit or module.

In other words, sending and receiving may be performed between devices. For example, sending and receiving may be performed between the second communication apparatus and the first communication apparatus. Alternatively, sending and receiving may be performed within a device. For example, sending and receiving may be performed between components, modules, chips, software modules, or hardware modules within the device through a bus, a wire, or an interface.

It can be understood that, before information is sent from a source end to a destination end, the information may undergo necessary processing, such as encoding or modulation. After receiving the information from the source end, the destination end may also perform corresponding processing, such as decoding or demodulation, in order to interpret the valid information from the source end. Similar expressions in this application can be understood in a similar manner, and further details are not described.

Third, in the embodiments of this application, "at least one" refers to one or more, and "a plurality of" refers to two or more. The term "and/or" describes an association relationship between associated objects, and indicates that three relationships may exist. For example, A and/or B may indicate the following cases: A alone, A and B, B alone, where A and B may be singular or plural. The character "/" generally indicates that an association relationship between the associated objects is an "or" relationship. However, this does not exclude the possibility that the association relationship between the associated objects is an "and" relationship. The specific meaning of the representation can be understood in combination with the context. The expression "at least one of the following items (pieces)" or a similar expression refers to any combination of these items, including any combination of a single item (piece) or multiple items (pieces). For example, "at least one of a, b, or c" may indicate the following cases: a, b, c; a and b; a and c; b and c; or a, b, and c. Here, a, b, and c may be singular or plural.

Fourth, in the embodiments of this application, each table is merely an example. The values of the information in each table are merely examples, and may be configured as other values. This application does not limit this. Each table does not constitute a limitation on the protection scope of this application. For example, each table in the foregoing text may be appropriately adjusted and deformed based on the table. For example, splitting, merging, and the like. For another example, the parameter name shown in the title of each table may also be another name that can be understood by the communication apparatus. A value or a representation manner of the parameter may also be another value or another representation manner that can be understood by the communication apparatus. For another example, when the foregoing tables are implemented, another data structure may also be used. For example, an array, a queue, a container, a stack, a linear list, a pointer, a linked list, a tree, a graph, a structure, a class, a heap, a hash table, or a hash table may be used.

5. In the embodiments of this application, descriptions such as "when...," "in the case of...," "if," and "when" all refer to a case in which, under a certain objective condition, a device (for example, the first device or the second device)) performs corresponding processing. This is not a limitation on time, nor does it require that the device (for example, the network device or the terminal device)) must have a determining action when implementing the device, nor does it imply the existence of other limitations.

Sixth, the predefinition in this application may be understood as: defining, predefining, storing, pre-storing, pre-negotiating, pre-configuring, solidifying, or pre-burning.

The technical solutions provided in this application may be applied to various communication systems, for example: a long term evolution (long term evolution, LTE) system, an LTE frequency division duplex (frequency division duplex, FDD) system, an LTE time division duplex (time division duplex, TDD) system, a sidelink (sidelink, SL) communications system, a worldwide interoperability for microwave access (worldwide interoperability for microwave access, WiMAX) communications system, a 5th generation (5th generation, 5G) mobile communications system, or a new radio access technology (new radio access technology, NR) and a satellite communications system. The 5G mobile communications system may include non-standalone networking (non-standalone, NSA) and/or standalone networking (standalone, SA).

The technical solutions provided in this application can also be applied to future communication systems, such as the sixth generation (6th generation, 6G)) mobile communication system, etc. This application does not impose any limitations in this regard.

The radio access network (radio access network, RAN) device in this application is a device with wireless receiving and transmitting functions. The radio access network device can provide wireless communication function services and can connect a terminal to a wireless network. The radio access network device may be a node in the radio access network, referred to as a RAN node.

In a possible scenario, the RAN node may be a base station (base station, BS), an evolved NodeB (evolved NodeB, eNodeB), a transmission reception point (transmission reception point, TRP), a home evolved NodeB (home evolved NodeB, or home Node B, HNB), a wireless fidelity (wireless fidelity, Wi-Fi) access point (access point, AP), a mobile switching center, a next generation NodeB (next generation NodeB, gNB) in a 5G mobile communications system, a next generation NodeB in a 6G mobile communications system, or a base station in a future mobile communications system, etc. The RAN node may alternatively be a device in a device-to-device (device to device, D2D) communication system, a vehicle external communication system (vehicle to everything, V2X), a machine-to-machine (machine to machine, M2M) communication system, an internet of things (internet to things, IoT) communication system, or a device that functions as a base station in these systems. The RAN node may alternatively be a RAN node in a non-terrestrial network (non terrestrial network, NTN). That is, the RAN node may be deployed on an aerial platform or a satellite. The RAN node may be a macro base station, or may be a micro base station, an indoor base station, a relay node, a donor node, or the like, or may be a wireless controller in a cloud radio access network (cloud radio access network, CRAN) scenario, a node in an open radio access network (open radio access network, O-RAN or ORAN) scenario, or the like. Optionally, the RAN node may alternatively be a server, a wearable device, a vehicle, or an in-vehicle device. For example, in a V2X technology, the RAN node may be a road side unit (road side unit, RSU).

In another possible scenario, multiple RAN nodes collaborate to assist a terminal in achieving wireless access. Different RAN nodes respectively implement some functions of a base station. For example, a RAN node may be a centralized unit (central unit, CU), a distributed unit (distributed unit, DU), a CU-control plane (control plane, CP), a CU-user plane (user plane, UP), or a radio unit (radio unit, RU), etc. The CU and DU may be separately disposed, or may also be included in the same network element, for example, in a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH).

In different systems, the CU (or CU-CP and CU-UP), DU, or RU may also have different names. However, a person skilled in the art can understand their meanings. For example, in the ORAN system, the CU may also be referred to as an open CU (O-CU), the DU may also be referred to as an open DU (O-DU), the CU-CP may also be referred to as an open CU-CP (O-CU-CP)), the CU-UP may also be referred to as an open CU-UP (O-CU-UP)), and the RU may also be referred to as an open RU (O-RU)).

Wherein, any one of the CU (or CU-CP, CU-UP)), DU, or RU may be implemented through a software module, a hardware module, or a combination of a software module and a hardware module. That is, the wireless access network device in this application may be a virtualized device, for example, implemented through general-purpose hardware and instantiated virtualized functions, or through dedicated hardware and instantiated virtualized functions. The general-purpose hardware may be a server, for example, a cloud server.

A terminal device in this application may also be referred to as user equipment (user equipment, UE), an access terminal, a subscriber unit, a subscriber station, a mobile station, a mobile station, a remote station, a remote terminal, a mobile device, a user terminal, a terminal, a wireless communications device, a user agent, or a user apparatus.

The terminal device may be a device that provides voice/data connectivity for a user, for example, a handheld device or a vehicle-mounted device with a wireless connection function. Currently, examples of some terminal devices may be: a mobile phone (mobile phone), a tablet computer (pad), a computer with a wireless transceiver function (such as a notebook computer or a palmtop computer), a mobile Internet device (mobile internet device, MID), and a virtual reality (virtual reality). VR) devices, augmented reality (augmented reality, AR) devices, wireless terminals in industrial control, wireless terminals in self driving, unmanned aircraft, wireless terminals in remote medical, smart grid (smart grid)), a wireless terminal in transportation safety, a wireless terminal in smart city, a wireless terminal in smart home, a cellular phone, a cordless phone, and a session initiation protocol protocol, SIP) telephone, a wireless local loop (WLL) station, a personal digital assistant (PDA), a handheld device with a wireless communication function, a computing device or other processing device connected to a wireless modem, an in-vehicle device, a wearable device, a terminal device in a 5G network, a terminal device in a future evolved public land mobile network (public land mobile network, PLMN), or the like.

Wherein, wearable devices can also be referred to as wearable smart devices. These devices utilize wearable technology to intelligently design and develop wearable devices for daily use. Examples include glasses, gloves, watches, clothing, and shoes. Wearable devices are portable devices that are directly worn on the body or integrated into the user's clothing or accessories. Wearable devices are not merely hardware devices; they also achieve powerful functions through software support, data interaction, and cloud interaction. Broadly speaking, wearable smart devices include those with comprehensive functions, large sizes, and the ability to perform complete or partial functions without relying on smartphones. Examples include smartwatches or smart glasses. Additionally, there are devices that focus on a specific type of application function and require coordination with other devices, such as smartphones. Examples include various smart wristbands or smart jewelry designed for monitoring physiological signs.

In addition, the terminal device may also be a terminal device in an IoT system. IoT is an important component of the future development of information technology. Its main technical feature is to connect items to the Internet through communication technology, thereby achieving human-machine interconnection and intelligent network interconnection between things. IoT technology can achieve massive connectivity, deep coverage, and terminal power saving through technologies such as narrowband (narrow band, NB) technology.

In addition, the terminal device may further include sensors such as a smart printer, a train detector, and a gas station. The main functions include collecting data (for some terminal devices), receiving control information and downlink data from a network device, and transmitting electromagnetic waves to transmit uplink data to the network device.

In this application, the terminal device may be a virtualized device. For example, the terminal device may be implemented by using general-purpose hardware and instantiated virtualization functions, or by using dedicated hardware and instantiated virtualization functions. The general-purpose hardware may be a server, for example, a cloud server.

It should be understood that, in this application, a specific form of the radio access network device and the terminal device is not limited.

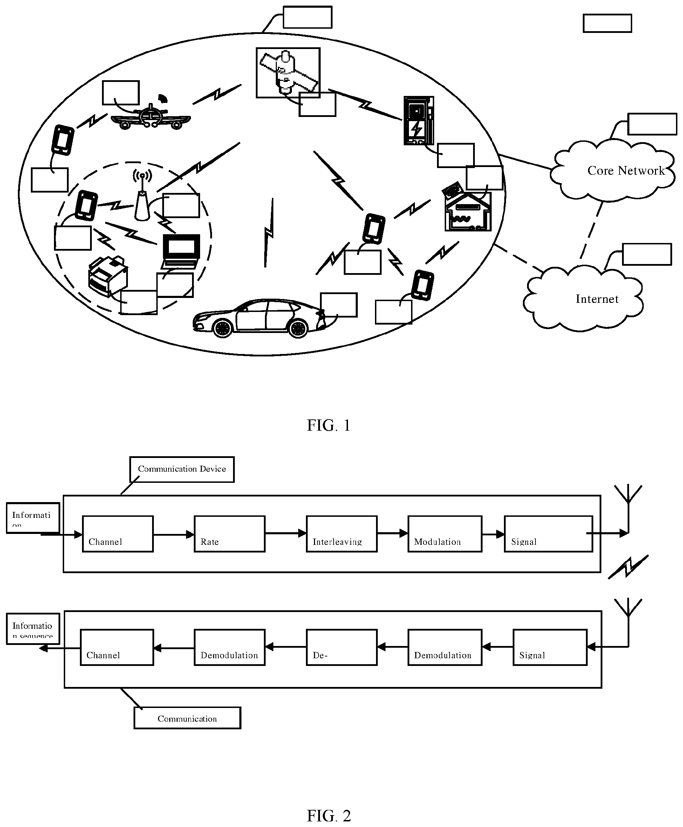

FIG. 1 is a schematic diagram of an architecture of a communications system 100 to which the method provided in the embodiments of this application is applicable. As shown in FIG. 1, the communications system 100 includes a radio access network 10 and a core network 20. Optionally, the communications system 100 may further include an internet 30. The radio access network 10 may include at least one radio access network device (for example, 110a and 110b in FIG. 1), and may further include at least one terminal (for example, 120a-120j in FIG. 1).

The terminal may be connected to the radio access network device in a wireless manner. The radio access network device may be connected to the core network in a wireless or wired manner. The core network device and the radio access network device may be independent and different physical devices, or may be integrated into a same physical device, where functions of the core network device and logical functions of the radio access network device are integrated. The terminal and the terminal, and the radio access network device and the radio access network device, may be connected to each other in a wired or wireless manner.

Between the radio access network device and the terminal, between the radio access network devices, and between the terminals, communication may be performed by using an authorized spectrum, or communication may be performed by using an unlicensed spectrum, or communication may be performed simultaneously by using both the authorized spectrum and the unlicensed spectrum. Communication may be performed by using a spectrum below 6 gigahertz (gigahertz, GHz)), or communication may be performed by using a spectrum above 6 GHz, or communication may be performed simultaneously by using both the spectrum below 6 GHz and the spectrum above 6 GHz. The spectrum resources used for wireless communication are not limited in embodiments of this application.

The radio access network device may be a base station deployed in the air, for example, may be a satellite base station 110a. or may be a base station deployed indoors, for example, may be a micro base station or an indoor station 110b.

The terminal may be a terminal deployed in the air, for example, a helicopter or an unmanned aerial vehicle 120i in FIG. 1. or may be a terminal deployed on the ground, for example, a mobile phone 120a, 120e, 120f, and 120j, a vehicle 120b, a computer 120g, or a printer 120h in FIG. 1.

The radio access network device and the terminal may be fixed or movable. For example, the radio access network device and the terminal may be deployed on land, including indoor or outdoor, handheld or vehicle-mounted. It can also be deployed on the water surface; It can also be deployed on aircraft, balloons and satellites in the air.

Roles of the radio access network device and the terminal may be relative. For example, the helicopter or UAV 120i in FIG. 1 may be configured as a mobile base station, for those 120j through 120i access to the radio access network 10, 120i is a base station; However, for 110a, 120i is a terminal, that is, communication between 110a and 120i is performed by using a wireless air interface protocol. Certainly, communication may also be performed between 110a and 120i by using an interface protocol between radio access network devices. In this case, compared with 110a, 120i is also a base station. Therefore, both the radio access network device and the terminal may be collectively referred to as a communications device, and 110a, 110b, and 120a to 120j in FIG. 1 may be referred to as communications devices with respective functions, for example, communications devices with a base station function or communications devices with a terminal function.

It should be understood that FIG. 1 is only a schematic diagram. The communications system may further include another device, for example, may further include a wireless relay device and a wireless backhaul device, which are not shown in FIG. 1.

For ease of understanding this embodiment of this application, the following briefly describes a processing process at the physical layer with reference to FIG. 2.

It should be understood that the signal processing process shown in FIG. 2 may be performed by the network device, or may be performed by the terminal device. This is not limited in this application.

As shown in fig. 2, communication device # 1 (for example, the access network device or the terminal device shown in FIG. 1) When sending information data, according to the size of the transport block supported by the system, (e.g., media access control (MAC)) layer) information data is divided into multiple transport blocks (transport block, TB), and CRC check is added to each transport block to obtain a sequence, where is also referred to as a payload (payload) of the transport block. If the size of the transport block to which the check is added exceeds the maximum code block length, the transport block needs to be divided into several code blocks (code block, CB). Each code block may include several bits in the transport block, and may further include CRC check bits of these bits, for example, a CRC check bit whose length is 24 bits. The code block may further include padding bits, so that a length of the code block meets a block length requirement. For example, LPDC coding is used as an example, and the length of the code block meets an integer multiple of an extension factor.

Communication device #1 may perform channel coding on each code block. For example, LDPC coding may be used to obtain the corresponding encoded code block. In this application, the information bit refers to the code block mentioned above. Each encoded code block may include multiple information bits in the code block before encoding, as well as check bits generated by encoding. In this application, these bits may be collectively referred to as encoded bits, and the sequence formed by multiple encoded bits may be referred to as an encoded bit sequence.

Communication device #1 may store the aforementioned encoded bit sequence in a circular buffer of communication device #1 for rate matching. Communication device #1 may select a segment of encoded bits from the circular buffer, perform interleaving processing on the segment, and then perform modulation processing, mapping the segment into modulation symbols, and transmitting a signal carrying the modulation symbols.

In the embodiments of this application, the length of the encoded bit sequence may refer to the length of the bit sequence output after the transport block is segmented into code blocks and LDPC coding is performed. More specifically, after the transport block is segmented into code blocks and LDPC coding is performed, the transport block is stored in a circular buffer, and then a specified length of bit data is continuously read out from a specified position in the buffer. When padding bits are encountered, they are automatically skipped.

Communications Device # 2 (for example, the access network device or the terminal device shown in FIG. 1) After demodulation processing and de-interleaving processing are performed on the received modulation symbols, soft values of the received coded bits may be stored in corresponding positions in the soft information buffer. If retransmission occurs, the communications device # 2 combines and stores the soft values of the coded bits retransmitted each time in a soft information buffer. The combination herein refers to combining the soft values of the coded bits received twice if positions of the coded bits received twice are the same.

The communications device # 2 may directly decode all soft values in the soft information buffer, for example, perform LDPC decoding, to obtain a corresponding information sequence. An information sequence obtained by channel decoding may be sent to an upper layer (for example, a MAC layer).

It should be understood that a process in which the communications device # 2 processes the received modulation symbol to obtain the information sequence may be regarded as a reverse process of a process in which the communications device # 1 processes to-be-sent information data to obtain the encoded bit sequence. The communications device # 1 and the communications device # 2 may perform communication by using a wireless technology or a wired technology, or perform optical communication, optical disk reading, or hard disk disk reading. For example, when the communications device # 1 sends a signal, the communications device # 1 is a sending device. In this embodiment of this application, the sending end device may be referred to as an encoding device. When the communications device # 2 receives a signal, the communications device # 2 is a receiving device. In this embodiment of this application, the receive end device may be referred to as a decoding (or referred to as a decoding) device. For example, the communications device # 1 may be the first communication apparatus in this application, and the communications device # 2 may be the second communication apparatus in this application.

For ease of understanding, related concepts in this application are first briefly described.
1. Codeword: a sequence consisting of a series of binary 0/1 data input by a source. The information sequence is divided into fixed-length message packets. Each message packet is marked as u and consists of f information bits or f information bits. The encoder converts each message packet u into a binary d-dimensional vector v (d>f) according to a given rule. The d-dimensional vector v is referred to as a codeword or a code vector of the message packet u, and a bit length of the d-dimensional vector v is d.
2. Block code (block code): Each message group has f information bits, that is, different messages may be carried, and each message corresponds to one codeword, that is, there are codewords. A vector set formed by codewords is referred to as a block code.
3. Linear block code (linear block code): In a block code, all messages h and codeword v have a one-to-one correspondence, that is, any different messages certainly correspond to different codewords, which is referred to as a linear block code, and is denoted as a linear (d, f) code. An (d, f) linear block code may be understood as encoding an information sequence with a length of f to obtain encoded bits with a code length of d.

Mathematically, the (d, f) linear code is an f-dimensional subspace of a vector space formed by all binary n-dimensional vectors, that is, f linear independent codewords (g1, g2, ..., gf) can be found, so that (d, (f) Each codeword in the linear code may be represented by a linear combination of the f vectors, that is, a matrix expression of the linear codeword is as follows:
v=

Here, bold lowercase letters represent vectors, bold uppercase letters represent matrices, is the message sequence, is the encoded codeword, G is called the generator matrix of the code set. It is composed of k linearly independent d-dimensional vectors, where the elements are either 0 or 1.

Parity check matrix H is the inverse matrix of the generator matrix in the binary sense, i.e., H = G^T. During decoding, this check relationship is relied upon to detect and correct errors.

4. Interleaving: This is a method of processing that transforms the order of a bit sequence. It can also be referred to as permutation. The purpose of interleaving is to counteract burst interference. After interleaving, the originally contiguous burst interference becomes random individual interference, which is beneficial for decoding.

5. LDPC code: This is a type of linear block code with a sparse parity check matrix. Its characteristic is that the parity check matrix of the LDPC code has a low density of non-zero elements (i.e., the number of non-zero elements is very small compared to the number of rows and columns). Due to the sparsity of the parity check matrix of the LDPC code, it has a large minimum distance, which also reduces the complexity of decoding. The error correction capability of this code is very close to the theoretical maximum value (i.e., the Shannon limit).

6. QC-LDPC code: This is a subclass of LDPC. The parity check matrix (parity check matrix) of QC-LDPC is obtained by extending a base matrix.

The QC-LDPC code, as a type of structured LDPC code, has been well applied in certain communication systems, such as 5G NR, due to its advantages of simple description, easy construction, and saving storage space.

However, in the 5G-NR standard, the QC-LDPC code has issues in short code design and error floor level. For example, the decoding performance of short codes with a length of less than 128 is poor. The error floor level for codewords of any length appears at a block error rate (BLER) of 10 -6. Moreover, when pursuing high throughput, it is necessary to increase the parallelism of decoding. However, due to the large input size of the LDPC long code decoding and the extremely high scheduling complexity, the decoder is prone to routing congestion. To avoid routing congestion, the input length of the decoder needs to be within the range of 1000 to 2000 bits. This limitation on code length results in a decrease in coding gain of at least 0.6 decibels (dB). At the same time, to improve the decoding rate, the number of decoding iterations and the length of the soft information in the decoding process need to be significantly reduced. This leads to a decrease in coding gain of at least 0.8 dB. Therefore, the parity check matrix of the current QC-LDPC code is difficult to meet the coding requirements of 5.5G/6G services for high reliability and high throughput.

In view of this, embodiments of this application provide a communication method and a related apparatus. In the method, a first communication apparatus and a second communication apparatus complete encoding and decoding by using a check matrix of a check matrix of an SC-LDPC code. However, check matrix sub-matrixes of the check matrix of the SC-LDPC code have a coupling feature, and therefore better bit error performance can be obtained. In addition, compared with the check matrix of the QC-LDPC code, the check matrix of the SC-LDPC code increases a degree of parallelism in decoding, and fast decoding can be implemented. so as to obtain better decoding performance.

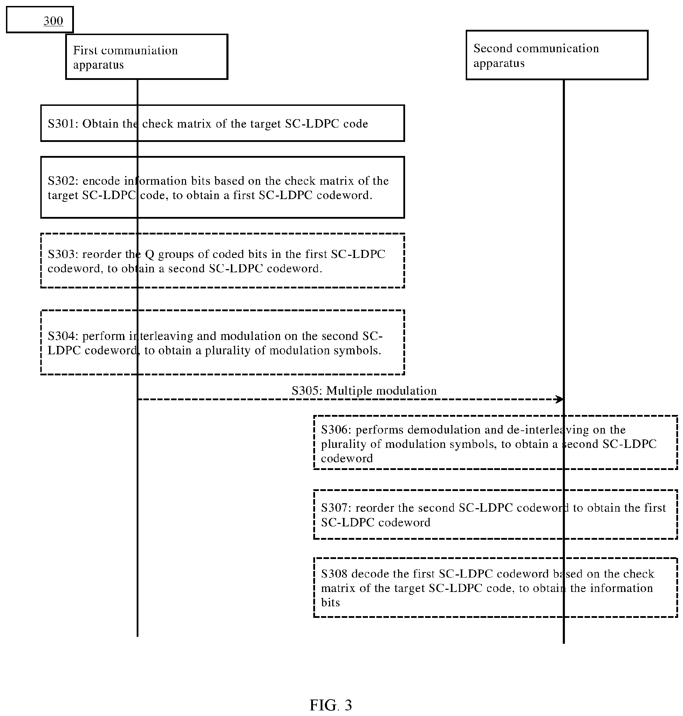

The following describes in detail the method provided in the embodiments of this application with reference to FIG. 3. The method 300 may be applied to the communications system shown in FIG. 1, but this embodiment of this application is not limited thereto.

In the flowchart shown in FIG. 3, the method is described from the perspective of communication apparatus interaction. However, this application does not limit an execution entity of the method. For example, the first communication apparatus in FIG. 3 may be a terminal device or a network device, or may be a component (such as a chip or a chip system) configured in the terminal device or the network device, or may be a logical module or software that can implement all or some functions of the terminal device or the network device. For another example, the second communication apparatus in FIG. 3 may be a terminal device or a network device, or may be a component (such as a chip or a chip system) configured in the terminal device or the network device. Alternatively, a logical module or software that can implement all or some functions of a terminal device or a network device may be used.

Figure 3 is a schematic flowchart illustrating the method 300 for generating a check matrix according to an embodiment of this application. As shown in Figure 3, the method 300 may include S301 to S308. The following provides a detailed description of the steps in the method 300.

S301: The first communication apparatus obtains the check matrix of the target SC-LDPC code.

In a possible implementation, the check matrix of the target SC-LDPC code is obtained by extracting from a preset check matrix of an SC-LDPC code, based on the target code rate, the length of the information bits, and the first mapping relationship.

Wherein, the number of rows in the check matrix of the preset SC-LDPC code is M, and the number of columns is N. The value of the elements in the check matrix of the preset SC-LDPC code is 0 or 1; or, the number of rows in the check matrix of the target SC-LDPC code is M, the number of columns is N, and the value of the elements in the check matrix of the preset SC-LDPC code is 0 or 1.

In another possible implementation, the check matrix of the target SC-LDPC code is determined based on the target code rate, the length of the information bits, and the first mapping relationship.

The first mapping relationship indicates a correspondence between the at least one code rate, the at least one information bit length, and a check matrix of the at least one SC-LDPC code. A quantity of rows and N columns in the check matrix of the target SC-LDPC code are M, values of elements in the check matrix of the target SC-LDPC code are 0 or 1, and both M and N are integers greater than 1.

In the foregoing two possible implementations, a 0th row to a (M-1)th row in the M rows and a 0th column to a (n-1)th column in the N columns constitute the first matrix. In addition, the elements in the jth column to the (j+n-1)th column in the N columns are obtained by cyclically shifting ((j/n)*m) rows downwards in the first matrix. the first matrix includes a second matrix whose row quantity is ((Z+1)*m) and a column quantity is n, and the second matrix is a matrix that includes an ith row to a (i+(Z+1)*m-1)th row in the first matrix. all other elements in the first matrix except the second matrix are 0, Z is an integer greater than 0, i is an integer greater than or equal to 0 and less than or equal to (M-(Z+1)*m), and j=n, 2*n, ..., y*n; and; (y+1)=N/n, M can be divisible by m, and n, m, and y are integers greater than 1.

The second matrix is obtained by arranging (Z+1) third matrices whose quantity of rows is m and whose quantity of columns is n in sequence according to rows, and Z third matrices exist in the (Z+1) third matrices. the quantity K of elements 1 included in the Z third matrices meets the following relationship with the quantity L of elements 1 included in the first matrix: K/L=Z*z%, K/L≤50%, (L-K) ≥ (K/Z), or a quantity of remaining elements 1 in the second matrix except the K elements 1 included in the Z third matrices is greater than or equal to a quantity of elements 1 included in at least one of the Z third matrices.

z is an integer less than or equal to 100*R, or z is an integer less than or equal to 100*(1-R). It should be understood that, when M and N are a quantity of rows and a quantity of columns of the check matrix of the target SC-LDPC code, R is a target code rate, or R is a maximum code rate that can be supported by the check matrix of the SC-LDPC code included in the first mapping relationship. or a minimum code rate; When M and N are respectively a quantity of rows and a quantity of columns of the preset check matrix of the SC-LDPC code, R is a maximum code rate or a minimum code rate that can be supported by the preset check matrix of the SC-LDPC code.

The second matrix mentioned above is obtained by sequentially arranging (Z+1) third matrices, each with a row count of m and a column count of n, in row order. This can be understood as the second matrix being composed of (Z+1) third matrices, each with a row count of m and a column count of n. That is, the second matrix starts with the 0th row of the second matrix and sequentially refers to each matrix composed of m rows of elements as a third matrix, thereby obtaining (Z+1) third matrices.

It can be understood that the length of the information bits in the above can be replaced by the target code length. For example, the check matrix of the target SC-LDPC code is determined based on the target code rate, the length of the information bits, and the first mapping relationship. This first mapping relationship indicates the correspondence between at least one code rate, at least one code length, and the check matrix of at least one SC-LDPC code.

In this application, in the check matrix of the target SC-LDPC, the elements of the (j+n-1)th column to the jth column in the N columns are obtained by performing a cyclic shift of (j/n)*m rows downward on the first matrix. Since the position range of the non-element in the first matrix is known, the position range of the non-zero element in the check matrix of the target SC-LDPC can be obtained. Therefore, the check matrix of the target SC-LDPC code has lower decoding scheduling complexity.

Optionally, the Z third matrices are summed to obtain a fourth matrix, and the Z+1 third matrices are summed to obtain a fifth matrix. The fourth matrix includes K elements, which are uniformly distributed among the L elements 1 included in the fifth matrix.

It can be understood that the fifth matrix and the fourth matrix have the same number of rows and columns (the number of rows is m, and the number of columns is n)).

It should be noted that, in this application, summing multiple matrices refers to performing modulo-2 summation on the multiple matrices. For example, modulo-2 summation is performed on the Z third matrices.

By using the following example, the meaning of uniform distribution is described. For example, the K elements 1 included in the fourth matrix are sequentially arranged according to the order of the matrix columns, to obtain a second list, where a length of the second list is K. Similarly, the L elements 1 included in the fifth matrix are sequentially arranged according to the order of the matrix columns, to obtain a first list, where a length of the first list is L. Three adjacent elements 1 in the second list are randomly selected, and the positions of the three adjacent elements 1 in the fourth matrix are determined. For example, the positions of the three elements 1 in the fourth matrix are (m1, n1)), (m2, n2)), and (m3, n3)), and then the positions of the three elements 1 located at (m1, n1)), (m2, n2)), and (m3, n3)) in the fifth matrix in the first list are determined: position 1, position 2, and position 3, where the number of elements 1 included between position 1 and position 2 is the same as the number of elements 1 included between position 2 and position 3. It should be understood that the elements 1 included in the fifth matrix and the fourth matrix may also be arranged by row.

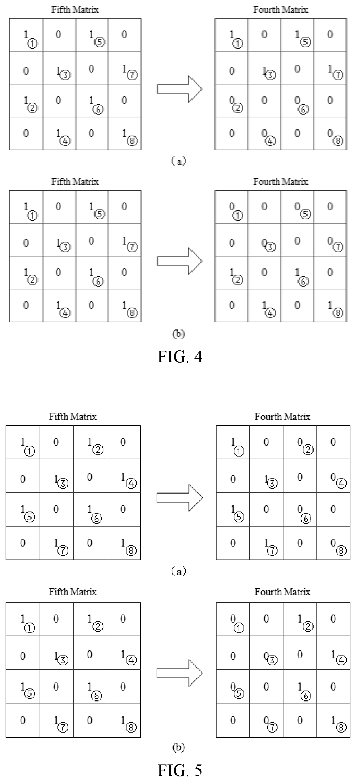

In other words, the K elements 1 included in the fourth matrix mentioned above are uniformly selected from the L elements 1 included in the fifth matrix. The following describes the manner of uniform selection with reference to FIG. 4 and FIG. 5.

As shown in (a) and (b) in FIG. 4 and (a) and (b) in FIG. 5, the fifth matrix has four rows and four columns, and includes eight elements 1. If four elements 1 need to be uniformly selected from the eight elements 1 included in the fifth matrix, then the fourth matrix needs to include four elements 1.

Example 1: The eight elements 1 in the fifth matrix are arranged by column and sequentially numbered. In this way, the fifth matrix shown in (a) and (b) in FIG. 4 can be obtained.

For the fifth matrix shown in (a) in FIG. 4, starting from the number ①, an element 1 is selected, and every other element 1 is selected. In this way, the numbers corresponding to the sequentially selected elements 1 are respectively ①, ③, ⑤, and ⑦. The element 1 that is not selected in the fifth matrix is updated to an element 0, and in this way, the fourth matrix shown in (a) in FIG. 4 can be obtained.

As shown in (b) of Figure 4, the fifth matrix is described. Starting from number ②, an element 1 is selected, and then every other element 1 is selected. The corresponding numbers for the sequentially selected element 1s are ②, ④, ⑥, and ⑧. The unselected element 1s in the fifth matrix are updated to element 0s, resulting in the fourth matrix shown in (b) of Figure 4.

Example 2: The eight element 1s in the fifth matrix are arranged in rows and sequentially numbered. This results in the fifth matrix shown in (a) and (b) of Figure 5.

Similarly, as shown in (a) of Figure 5, the fifth matrix is described. Starting from number ①, an element 1 is selected, and then every other element 1 is selected. The corresponding numbers for the sequentially selected element 1s are ①, ③, ⑤, and ⑦. The unselected element 1s in the fifth matrix are updated to element 0s, resulting in the fourth matrix shown in (a) of Figure 5.

As shown in (b) of Figure 5, the fifth matrix is described. Starting from number ②, an element 1 is selected, and then every other element 1 is selected. The corresponding numbers for the sequentially selected element 1s are ②, ④, ⑥, and ⑧. The unselected element 1s in the fifth matrix are updated to element 0s, resulting in the fourth matrix shown in (b) of Figure 5.

It may be understood that a manner of selecting the K elements 1 included in the fourth matrix is not limited in this application. For example, the K elements 1 may be randomly selected. For another example, when the fifth matrix includes at least K elements 1 with different row sequence numbers and column sequence numbers, the K elements 1 may be randomly selected from the fifth matrix including at least K elements 1 with different row sequence numbers and column sequence numbers. or when the fifth matrix includes at least K' (K' is an integer greater than 0 and less than K) elements 1 whose row sequence numbers and column sequence numbers are different, The K elements 1 include the at least K' (K' is an integer greater than 0 and less than K) elements 1 whose row sequence numbers and column sequence numbers are different.

It should be noted that, when the K elements are evenly selected from the L elements, if x=L/K, and x is an integer, one element 1 may be selected from the L elements at intervals of (x-1) element 1s, to obtain the L elements 1. If x=L/K, and x is not an integer, one element 1 may be first selected from the L elements at intervals of (-1) element 1s. Then, (L-(12/(-1))) elements 1 are randomly or evenly selected from the remaining elements 1, to obtain L elements 1. where indicates rounding up.

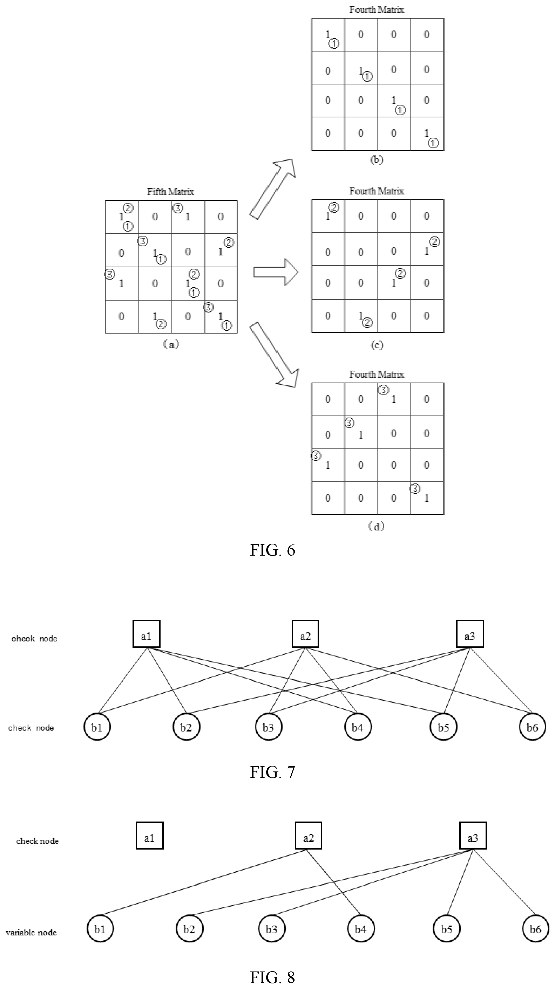

For example, with reference to FIG. 6, the following describes a manner of selecting the K elements 1 from the L elements 1.

As shown in (a) in FIG. 6, a quantity of rows and a quantity of columns of the fifth matrix are 4, the fifth matrix includes eight elements 1, and the eight elements 1 include a plurality of groups of elements 1. In addition, each group of elements 1 includes four elements 1 with different quantities of rows and different quantities of columns. In the fifth matrix shown in FIG. 6, elements 1 identified by a same number belong to one group.

For example 1, if four elements 1 need to be randomly selected from the eight elements 1 included in the fifth matrix, a group of elements 1 may be randomly selected from the eight elements as the element 1 included in the fourth matrix.

As shown in (a) in FIG. 6, the fifth matrix includes three groups of elements 1, and four elements 1 included in each group of elements 1 have different quantities of rows and columns. If the group of elements 1 identified by the number 1 is used as the four to-be-selected elements 1, a fourth matrix shown in (b) in FIG. 6 may be obtained. If the group of elements 1 identified by the number 2 is used as the four to-be-selected elements 1, a fourth matrix shown in (c) in FIG. 6 may be obtained. If the group of elements 1 identified by the number 3 is used as the four to-be-selected elements 1, a fourth matrix shown in (d) in FIG. 6 may be obtained.

Example 2: If it is necessary to randomly select six elements 1s from the eight elements 1s included in the fifth matrix, a group of elements 1s may be randomly selected from the eight elements, and two elements 1s may be randomly selected or evenly selected from the remaining elements 1s in the group of elements 1s obtained by dividing the selected elements. is used as the element 1 included in the fourth matrix.

Example 3: If two elements 1 need to be randomly selected from the eight elements 1 included in the fifth matrix, a group of elements 1 may be randomly selected from the eight elements, and two elements 1 are randomly selected or evenly selected from the group of elements 1. is used as the element 1 included in the fourth matrix.

Optionally, the element 1 included in each of the Z third matrices is evenly distributed in the K elements 1 included in the fourth matrix.

Similarly, if Z=2, the third matrix # 1 and the third matrix # 2 may be obtained, and the elements 1 included in the third matrix # 1 are sequentially arranged according to a sequence of matrix columns, to obtain a list 1 whose length is K1 (K1 is an integer greater than 0 and less than K). arranging the elements 1 included in the third matrix 2 in sequence according to a matrix column order, to obtain a list 2 whose length is K2 (K2=K-K1). Any two elements 1 are selected from the list 2, but it needs to be ensured that a location of an element selected from the list 1 in the list 1 is the same as a location of an element selected from the list 2 in the list 2, for example, both are located in the location 1 and the location 2 in the list. If locations of the two elements 1 selected in the list 1 in the third matrix 1 are respectively (ml, nl) and (m2, n2), locations of the two elements 1 selected in the list 2 in the third matrix 2 are respectively (m3, n3) and (m4, n4), Then, locations that are in the second list and that are in the fourth matrix and that are located at the (ml, nl), (m2, n2), (m3, n3), and (m4, n4) locations are determined: the location 1, the location 2, the location 3, and the location 4; and In addition, the element 1 included between the location 1 and the location 3 is the same as the element 1 included between the location 2 and the location 4. It should be understood that the elements 1 included in the third matrix 1, the third matrix 2, and the fourth matrix may alternatively be arranged by row.

Optionally, the element 1 included in each of the Z third matrices is randomly distributed in the K elements 1 included in the fourth matrix.

In other words, after the K elements 1 and the numerical values of Z are determined, the encoding apparatus or the decoding apparatus may group the K elements 1 into Z groups, and a quantity of elements 1 included in each group may be the same or different. If the K elements 1 are obtained in a row (or column) arrangement manner, and each group includes a plurality of elements 1, the K elements 1 included in each group may be continuous or discontinuous.

S302. The first communication apparatus encodes information bits based on the check matrix of the target SC-LDPC code, to obtain a first SC-LDPC codeword.

The length of the information bits is the length of the information bits used to determine the check matrix of the target SC-LDPC code.

In a possible implementation, the preset check matrix of the SC-LDPC code or the check matrix of the target SC-LDPC code may be further determined by using the following step 1 to step 4. It should be understood that step 1 to step 4 may be performed by the encoding apparatus, or may be performed by the decoding apparatus.

Step 1: Determine a matrix 1 based on the code rate R and the length l of the information bits. a quantity of rows and columns in the matrix 1 is a, a quantity of columns is b, a value of an element in the matrix 1 is 0 or 1, the matrix 1 includes Y elements 1, R=1-a/b, l=k*b, and k is an integer greater than 0. a, b, and Y are integers greater than 1.

If each row in the matrix 1 may be corresponding to one check node, and each column is corresponding to one variable node, the element 0 in the matrix 1 indicates that the corresponding variable node is not connected to the check node, and the element 1 in the matrix 1 indicates that the corresponding variable node is connected to the check node. In other words, each element 1 in the matrix 1 corresponds to one side, and each side connects a variable node corresponding to a column in which the element 1 is located and a check node corresponding to a row in which the element 1 is located. Because the matrix 1 includes the Y elements 1, the matrix 1 includes the Y edges.

In a possible implementation, the determining a matrix 1 based on the code rate R and the length l of the information bits includes: the code rate R and the length l of the information bits, and a matrix 5 is determined. A quantity of rows in the matrix is (a/D), and a quantity of columns in the matrix is (b/D). In addition, the matrix 5 includes (Y/D) edges, and D is an integer greater than 1. The matrix 5 is extended by using a quasi-circular (quasicycle, QC) algorithm, to obtain the foregoing matrix 1, where D is an extension coefficient.

The aforementioned matrix 1 can be understood as the fifth matrix in this application.

Step 2: Based on matrix 1, obtain a matrix 2 and Z matrices 3. The matrix 2 and each of the Z matrices 3 have the same number of rows and columns, and the number of rows is a, and the number of columns is b. The sum of the matrix 2 and the Z matrices 3 is matrix 1.

Wherein, matrix 2 is the matrix corresponding to matrix 1 after removing W edges from the Y edges. Each of the Z matrices 3 includes at least one edge, at least one edge belongs to the W edges, and any two of the Z matrices 3 include different edges. W/Y=Z*z%.

In a possible implementation, the W edges may be selected from the Y edges at equal intervals (or referred to as uniform selection)). Alternatively, it can be said that each of the W elements 1 is selected from the Y elements 1 included in matrix 1 at equal intervals.

The specific selection method can refer to the related descriptions in Figures 4 and 5 in the previous content. Details are not described herein again.

In a possible implementation, the element 1 included in each matrix 3 is selected (or referred to as evenly selected) from the W elements 1 at a medium interval. For a specific selection manner, refer to related description in FIG. 6. Details are not described herein again.

The matrix 2 and the Z matrices 3 may be understood as (Z+1) third matrices in this application. The Z matrices 3 may be understood as Z third matrices in this application.

Step 3: Obtain a matrix 4 based on the matrix 2 and the Z matrices 3, where a quantity of rows in the matrix 4 is ((Z+1)*a), and a quantity of columns in the matrix 4 is (b*F).

The matrix 4 is a matrix obtained by sequentially arranging the matrix 2 and the Z matrices 3 by row. An arrangement order of the matrix 2 and the Z matrices 3 is not limited in this application. It should be understood that an arrangement order of the matrix 2 and the Z matrices 3 may be predefined. The following are the three permutations:
Example 1: If the matrix 2 is denoted as H2, the Z matrices 3 are denoted as H31, H32, ..., and H3Z respectively, and the matrix 4 is denoted as H4. H4 meets the following requirements:
   ;
Example 2: If the matrix 2 is denoted as H2, the Z matrices 3 are denoted as H31, H32, ..., and H3Z respectively, and the matrix 4 is denoted as H4. H4 meets the following requirements:
   ;
Example 3: If the matrix 2 is denoted as H2, the Z matrices 3 are respectively denoted as H31, H32, ..., and H3Z, and the matrix 4 is denoted as H4. H4 meets the following requirements:
   ;

Step 4: Determine the coupling chain length k, and sequentially place the k matrices 4 according to a preset manner, to obtain the check matrix of the SC-LDPC code.

In the check matrix of the SC-LDPC code, all positions except the k matrices 4 are 0.

The number of columns in the check matrix of the SC-LDPC code is k times the number of columns in matrix 3, and the number of rows is (k+Z) times the number of rows in matrix 3. For example, if matrix 3 has 5 columns, then the number of columns in the check matrix of the SC-LDPC code is 5*k. Another example, if matrix 3 has 3 rows, then the number of columns in the check matrix of the SC-LDPC code is 3*(k+Z)).

In one possible implementation, step 4 may include: using a QC algorithm to expand matrix 4 to obtain matrix 5, where the number of rows in matrix 5 is ((Z+1)*a*F)), the number of columns is (b*F), and F is an expansion coefficient; determining the coupling chain length k; and sequentially placing matrix 5 according to a preset position to obtain the check matrix of the SC-LDPC code.

As described above, matrices 4 and 5 can be understood as the second matrix in this application.

As an example, the following uses the number of check nodes a=3, the number of variable nodes b=6, and the number of edges included in matrix 1, Y=12. The process of obtaining the check matrix of the SC-LDPC code is described in detail with reference to FIG. 7 to FIG. 9. It should be understood that matrix 1 is a matrix obtained through expansion using the QC algorithm.

As shown in FIG. 7, three check nodes are sequentially numbered to obtain check node a1, check node a2, and check node a3. Six variable nodes are sequentially numbered to obtain variable node b1, variable node b2, variable node b3, variable node b4, variable node b5, and variable node b6. Wherein, a1 is respectively connected to b1, b2, b4, and b5, a2 is respectively connected to b1, b3, b4, and b6, and a3 is respectively connected to b2, b3, b5, and b6, obtaining 12 edges.

As shown in FIG. 7, based on the three check nodes, six variable nodes, and the connection relationships between the check nodes and the variable nodes shown in FIG. 7, matrix 1 can be obtained, which is denoted as H1:
;
wherein, matrix 1 includes 12 elements 1.

Taking R=0.4, z=25 as an example, according to the relationship satisfied between W and Y: W/Y=Z*z%, it can be obtained that W=6. From the 12 edges shown in Figure 7, 6 edges are selected at equal intervals to be disconnected. For example, the connections between a1 and b1, a1 and b2, a2 and b3, a1 and b4, a1 and b5, and a2 and b6 are disconnected. This can result in a connection diagram of variable nodes and check nodes as shown in Figure 8.

Based on the three check nodes, six variable nodes, and the connection relationships between the check nodes and variable nodes shown in Figure 8, matrix 2 can be obtained, denoted as H2:
;

The matrix 2 includes six elements 1. H2 may be understood as a remaining third matrix in the (Z+1) third matrices except the Z third matrices in this application.

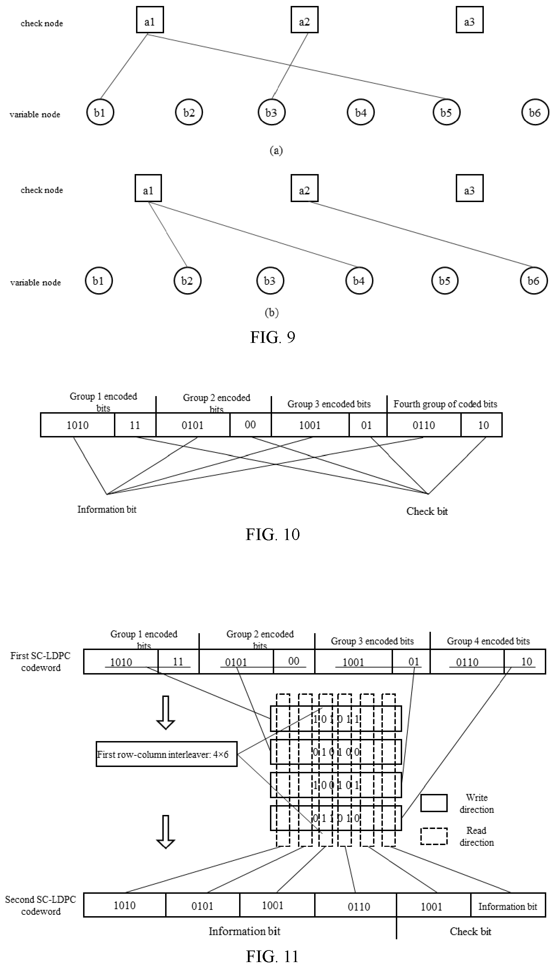

Z=2 is used as an example. Three edges are selected from the six interrupted edges in FIG. 7: a line between a1 and b1, a line between a2 and b3, and a line between a1 and b5, and a line between a1 and b5 is disconnected. A schematic diagram of a connection between a variable node and a check node shown in (a) in FIG. 9 may be obtained. Three edges are selected from the six interrupted edges in FIG. 7 at a medium interval: a line between a1 and b2, a line between a1 and b4, and a line between a2 and b6. A schematic diagram of a connection between a variable node and a parity node shown in (b) in FIG. 9 may be obtained.

Based on the three parity nodes, the six variable nodes, and the connection relationship between the parity nodes and the variable nodes that are shown in (a) and (b) in FIG. 9, two matrices 3 may be obtained, respectively denoted as H31 and H32:
,;

Each matrix 3 includes six elements 1. H31 and H32 may be understood as Z third matrices in this application.

Based on the aforementioned matrix 2 and two matrices 3, matrix 4 can be obtained, denoted as H4:
;
wherein, the matrix 4 includes 12 elements 1, which is the same as the number of elements 1 included in matrix 1. The matrix 4 can be understood as the second matrix in this application.

For example, when the coupling chain length k=3, a parity check matrix of the SC-LDPC code can be obtained, denoted as H5:
;

H2, H31, and H32 have a same quantity of rows and a same quantity of columns. "0" indicates an all-zero matrix, a quantity of rows is the same as a quantity of rows of H2, and a quantity of columns is the same as a quantity of columns of H2. A matrix formed by elements in the first column may be understood as the first matrix in this application.

Optionally, the obtaining, by the first communication apparatus, a first SC-LDPC codeword based on the information whose length is l of the check matrix encoding of the target SC-LDPC code includes: grouping, by the first communication apparatus, information bits whose length is l into Q (Q = N/n) groups; and; The Q groups of information bits are encoded based on the check matrix of the target SC-LDPC code, to obtain the first SC-LDPC codeword that includes Q groups of coded bits, where each group of coded bits in the Q groups of coded bits includes one group of information bits and one group of check bits.

Each group of information bits includes at least one information bit, and quantities of information bits included in any two groups of information bits in the Q groups of information bits are the same or different.

For example, when the Q groups of information bits include a same quantity of information bits, each group of information bits includes A (A=l/Q) information bits, and each group of check bits in the Q groups of check bits includes B (B=n-l/Q) check bits. A and B are integers greater than 0.

It may be understood that the A information bits may be continuously arranged.

It may be further understood that, in each group of coded bits in the Q groups of coded bits, the information bit is located before the check bit. In other words, when the first communication apparatus encodes the Q groups of information bits, each group of information bits corresponds to the first A columns of each first matrix.

For example, if the Q groups of coded bits in the first SC-LDPC codeword are sequentially and consecutively numbered starting from 1, A check relationship exists between any check bit in the qth group of coded bits in the Q groups of coded bits and at least one group of coded bits in p consecutive groups of coded bits before the qth group of coded bits, q is an integer greater than 1 and less than Q, and p is an integer greater than 0 and less than p.

It may be understood that the p consecutive groups of coded bits before the qth group of coded bits refer to the q-1th group of coded bits to the q-pth group of coded bits.

The following uses Q=4, A=4, and B=2 as an example. (That is, the first SC-LDPC codeword includes four groups of coded bits, and each group of coded bits includes four information bits and two check bits.). A first SC-LDPC codeword is described with reference to FIG. 10.

As shown in FIG. 10, the first SC-LDPC codeword is 101011 010100 100101 011010. A first group of information bits in the first group of coded bits is 1010, and a first group of check bits is 11. A second group of information bits in the second group of coded bits is 0101, and a second group of check bits is 00. A third group of information bits in the third group of coded bits is 1001, and a third group of check bits is 01. A fourth group of information bits in the fourth group of coded bits is 0110, and a fourth group of check bits is 10.

For example, when q=3 and p=2, it is obtained that any check bit 01 in the third group of coded bits has a check relationship with at least one group of coded bits in the second group of coded bits (010100) and the third group of coded bits (100101).

Optionally, after S302, the method 300 may further include S303 to S305.

S303. The first communication apparatus reorders the Q groups of coded bits in the first SC-LDPC codeword, to obtain a second SC-LDPC codeword.

The second SC-LDPC codeword includes Q groups of information bits and Q groups of check bits, and a location relationship between the Q groups of information bits and the Q groups of check bits in the second SC-LDPC codeword meets any one of the following characteristics 1 to 5:

Feature 1: The Q groups of information bits are located before the Q groups of check bits.

With reference to the first SC-LDPC codeword shown in FIG. 10, the second SC-LDPC codeword may be: 1010 0101 1001 0110 11 00 01 10.

Feature 2: In the Q groups of coded bits, q groups of coded bits used as a decoding start point are located before other groups of coded bits.

With reference to the first SC-LDPC codeword shown in FIG. 10, when q=2, and the decoding start point is the first group of coded bits and the fourth group of coded bits, the second SC-LDPC codeword may be 1010 11 0110 10 0101 00 1001 01. Or: 11 10 10 10 0110 01 1001 10 0110.

Feature 3: In the Q groups of coded bits, q groups of coded bits that are used as a decoding start point are located before other groups of coded bits, and information bits in each group of coded bits are located before check bits.

Optionally, an information bit in another group of coded bits in the feature 3 is located before a check bit in another group of coded bits.

With reference to the first SC-LDPC codeword shown in FIG. 10, when q=2, and the start points of sub-decoding are respectively the first group of coded bits and the fourth group of coded bits, the second SC-LDPC codeword may be: 1010 11 0110 10 0101 00 1001 01.

Feature 4: The q groups of coded bits that are used as the decoding start point in the Q groups of coded bits are located before the other groups of coded bits, and the information bits in the q groups of coded bits are located before the check bits in the q groups of coded bits.

With reference to the first SC-LDPC codeword shown in FIG. 10, when q=2, and the decoding start point is respectively the first group of coded bits and the fourth group of coded bits, the second SC-LDPC codeword may be: 1010 0110 11 10 1001 01 0110 10.

Alternatively, feature 5: Information bits in q groups of coded bits that are used as the decoding start point in Q groups of coded bits are located before information bits in other groups of coded bits, and check bits in the q groups of coded bits are located before check bits in the other groups of coded bits. In addition, the information bits in the Q groups of coded bits are located before the check bits.

With reference to the first SC-LDPC codeword shown in FIG. 10, when q=2, and the start points of sub-decoding are respectively the first group of coded bits and the fourth group of coded bits, the second SC-LDPC codeword may be: 1010 0110 0101 1001 11 10 00 01.

The other groups of coded bits are remaining groups of coded bits in the Q groups of coded bits except the q groups of coded bits. In other words, the other groups of coded bits are coded bit groups that are in the Q groups of coded bits and that are not used as a decoding start point.

Optionally, a location relationship between the foregoing other groups of coded bits meets the following requirement: the other groups of coded bits are arranged in ascending order of the first distance. The first distance is a quantity of coded bit groups between q groups of coded bits and each group of coded bits in the other groups of coded bits in the first SC-LDPC codeword.

In other words, r groups of coded bits adjacent to q groups of codes in other groups of coded bits are located before s groups of coded bits that are not adjacent to q groups of codes in other groups of coded bits, The y groups of coded bits adjacent to the r groups of coded bits in the s groups of coded bits are located before the w groups of coded bits that are not adjacent to the r groups of coded bits in the s groups of coded bits, and so on, until the Q groups of coded bits are arranged. s, r, y, and w are integers greater than or equal to 0 and less than Q.

For example, if the first group of coded bits and the Qth group of coded bits in the first SC-LDPC codeword serve as the decoding start point, In this case, the (2t-1)th group of coded bits in the Q groups of information bits in the second SC-LDPC codeword is a tth group of coded bits in the Q groups of coded bits in the first SC-LDPC codeword. a tth group of coded bits in Q groups of coded bits in the second SC-LDPC codeword is a (Q-t+1)th group of coded bits in Q groups of information bits in the first SC-LDPC codeword, where t=1, 2, ..., ceil (Q/2), where ceil () indicates rounding up.

In a possible implementation, the first communication apparatus reorders the Q groups of encoded bits in the first SC-LDPC codeword to obtain a second SC-LDPC codeword, including: the first communication apparatus performs interleaving processing on the first SC-LDPC codeword by using a first row-column interleaver, to obtain the second SC-LDPC codeword, wherein the number of rows of the first row-column interleaver is Q, and the number of columns is (A+B).

The following uses the first SC-LDPC codeword shown in FIG. 10 as an example to describe a process of obtaining a second SC-LDPC by using a first row-column interleaver with reference to FIG. 11.

As shown in FIG. 11, it is known that Q=4 and A+B=6, and it may be obtained that a quantity of rows and a quantity of columns of the first row-column interleaver are 4 and a quantity of columns is 6. A second SC-LDPC codeword that may be obtained by sequentially writing the 24 bits in the first SC-LDPC codeword into the second row-column interleaver in a left-right manner, and then reading bits in each column in a top-down manner: 1010 0101 1001 0110 1001 1010. In the second SC-LDPC codeword obtained based on the first row-column interleaver, all the information bits are arranged before all the check bits.

In another possible implementation, the reordering, by the first communication apparatus, Q groups of coded bits in the first SC-LDPC to obtain a second SC-LDPC codeword includes: the first communication apparatus based on the decoding mode for the first SC-LDPC codeword, where re-order the Q groups of coded bits to obtain the second SC-LDPC codeword.

The decoding mode includes bidirectional sliding window decoding and parallel sliding window decoding. Bidirectional sliding window decoding means that the second communication apparatus performs sliding window decoding towards the middle encoded bit group starting from the coded bit group at the beginning and the coded bit group at the end of the first SC-LDPC codeword; and; Parallel sliding window decoding means that the second communication apparatus performs sliding window decoding starting from multiple encoded bit groups in the Q groups of encoded bits included in the first SC-LDPC codeword.

Optionally, the decoding mode is bidirectional sliding window decoding, and the q groups of coded bits are the first group of coded bits and the Qth group of coded bits in the first SC-LDPC codeword.

For example, the first communication apparatus may cyclically shift the first SC-LDPC codeword backward by a length of one group of coded bits, and put the Qth group of coded bits and the first group of coded bits before another coded bit group.

An arrangement order of the two groups of coded bits used as the decoding start point is not limited in this application. For example, the first group of coded bits may be located before the fourth group of coded bits, or the fourth group of coded bits may be located before the first group of coded bits.

Optionally, when the decoding mode is parallel sliding window decoding, q is an integer greater than 2 and less than or equal to Q, and the q groups of coded bits are q groups of coded bits that are in the Q groups of coded bits and that are used as a decoding start point.

It can be understood that the start point of parallel sliding window decoding may be indicated by the second communication apparatus to the first communication apparatus. Alternatively, the starting point of the parallel-to-sliding window decoding is predefined.

For example, the decoding start point predefined in the protocol or the decoding start point indicated by using signaling may be one or more bit (bit) locations. The one or more bit positions may be determined by using a bit length, where the bit length may be a distance from a start bit of the SC-LDPC codeword, or a distance from an end bit of the SC-LDPC codeword. Alternatively, the one or more bit locations may be determined by using a proportion, and the proportion may be a proportion relative to the code length, for example, a half of the code length or a quarter of the code length.

An arrangement order of the plurality of groups of coded bits used as a decoding start point is not limited in this application. For example, the plurality of groups of coded bits are separately a first group of coded bits, and the third group of coded bits may be that the first group of coded bits is located before the fourth group of coded bits. Alternatively, the fourth group of coded bits is located before the first group of coded bits.

S304: The first communication apparatus performs interleaving and modulation on the second SC-LDPC codeword, to obtain a plurality of modulation symbols.

Herein, interleaving refers to processing the second SC-LDPC codeword by using a row-column interleaver. Specifically, the second SC-LDPC codeword is written into the row-column interleaver by row, and then read out by column.

Modulation refers to the process in which all bits included in the second SC-LDPC codeword are mapped to one modulation symbol. In this process, each bit in the second SC-LDPC codeword needs to be mapped, and each bit can only be mapped once. Herein, P is a modulation order, which is related to a modulation scheme. For example, 256 quadrature amplitude modulation (quadrature amplitude modulation, QAM) is used to modulate the third SC-LDPC codeword, and P=8; or, 64QAM is used to modulate the third SC-LDPC codeword, and P=6. For related descriptions of obtaining the modulation order based on the modulation scheme, refer to existing descriptions. Details are not described herein again. It should be understood that the first communication apparatus also uses another modulation scheme (for example, phase shift keying modulation) to modulate the second SC-LDPC codeword.

It should be noted that in S304, when the Q groups of encoded bits in the first SC-LDPC are reordered, the positions of the important bits in the second SC-LDPC are related to the reliability of the bit sub-channels in the multiple bits corresponding to each symbol in the selected modulation scheme. For example, in the multiple bits corresponding to each symbol, the reliability of the bits in the front is relatively high, and the reliability of the bits in the back is relatively low. In this case, the important bits in the Q groups of encoded bits need to be arranged in front of the non-important bits. Alternatively, in the multiple bits corresponding to each symbol, the reliability of the bits in the front is relatively low, and the reliability of the bits in the back is relatively high. In this case, the important bits in the Q groups of encoded bits need to be arranged behind the non-important bits. That is, the arrangement order of the Q groups of encoded bits in the second SC-LDPC codeword is determined based on the selected modulation scheme.

In a possible implementation, the interleaving and modulation performed by the first communication apparatus on the second SC-LDPC codeword include: The first communication apparatus may perform interleaving processing on the second SC-LDPC codeword by using a second row-column interleaver, to obtain a third SC-LDPC codeword; and mapping P consecutive bits in the second SC-LDPC codeword to one modulation symbol, to obtain a plurality of modulation symbols.

The third SC-LDPC codeword includes (Q*A) information bits and (Q*B) check bits, a quantity of rows of the second row-column interleaver is P, and a quantity of columns is D=ceil((A+B)*Q/P).

It may be understood that each bit in the first SC-LDPC codeword can be mapped to only one modulation symbol. In other words, bits mapped to different modulation symbols in the foregoing plurality of modulation symbols are different.

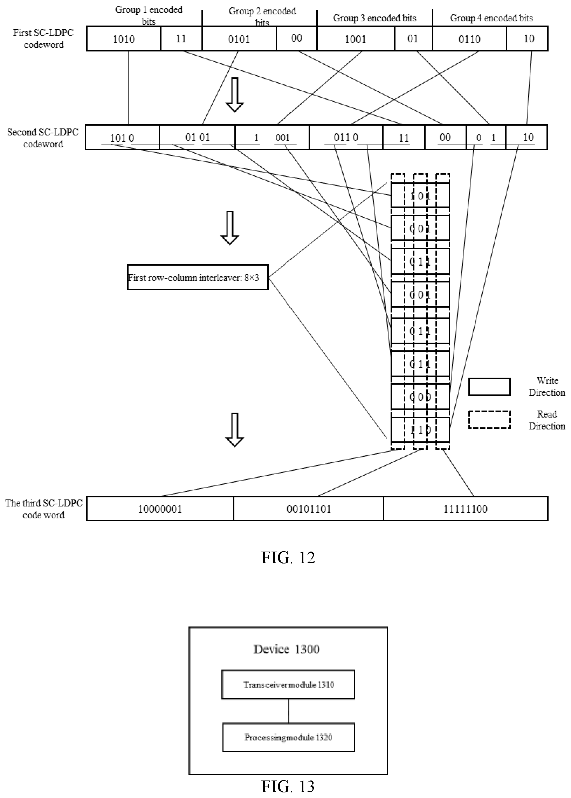

The following describes a process of obtaining the third SC-LDPC through interleaving and modulation by using an example in which the modulation scheme is 256QAM and with reference to the first SC-LDPC codeword shown in FIG. 12.

As shown in FIG. 12, a modulation order P corresponding to 256QAM is 8, and D is set to ceil((4 + 2) * 4/8) = 3. A quantity of rows and a quantity of columns of the second column-column interleaver are obtained as 8, and a quantity of columns is obtained as 3. If the four groups of coded bits in the first SC-LDPC codeword shown in FIG. 10 are reordered, the obtained second SC-LDPC codeword is: 1010 0101 1001 0110 11 00 01 10; and; continue to perform interleaving processing on the second SC-LDPC codeword by using a row-column interleaver with a quantity of 8 rows and a quantity of 3 columns, that is, 24 bits in the second SC-LDPC codeword are sequentially written into the row-column interleaver in a left-right manner. Then, bits in each column are read out in a top-down manner, to obtain the third SC-LDPC codeword: 10000001 00101101 11111100.

Then, the first communication apparatus modulates, by using 256QAM, the third SC-LDPC codeword obtained based on the manner shown in FIG. 11, to obtain three modulation symbols. 10000001 corresponds to one symbol, 00101101 corresponds to one symbol, and 11111100 corresponds to one symbol.

For 256QAM, each modulation symbol may be corresponding to eight bit channels, and in the eight bit channels, reliability of a bit channel in a first position is higher than reliability of a bit channel in a second position. Because the important bits in the second SC-LDPC codeword are arranged in the front, the important bits may be modulated to a bit channel with higher reliability by modulating the third SC-LDPC codeword.

In this embodiment of this application, the Q groups of coded bits in the first SC-LDPC codeword are reordered, and relatively important bits in the Q groups of coded bits are arranged before unimportant bits, to obtain the second SC-LDPC. Then, interleaving is performed on the second SC-LDPC. Modulation. In this way, important bits in the first SC-LDPC codeword can be mapped to bits with relatively high reliability in P bits corresponding to the modulation symbol, thereby improving decoding performance.

S305: The first communication apparatus sends a plurality of modulation symbols to the second communication apparatus. Correspondingly, the second communication apparatus receives the plurality of modulation symbols from the first communication apparatus.

Optionally, after S305, the method 300 may further include: S306 to S308.

S306: The second communication apparatus performs demodulation and de-interleaving on the plurality of modulation symbols, to obtain a second SC-LDPC codeword.

Herein, demodulation is the inverse process of modulation, referring to the process of demodulating the plurality of modulation symbols into a plurality of bits. De-interleaving is the inverse process of interleaving, that is, the plurality of bits obtained through demodulation are written into a row-column interleaver by column, and then the plurality of bits written in the interleaver are read out by row. Therefore, details are not described herein again.

For the description of the second SC-LDPC codeword, refer to the related descriptions above. Details are not described herein again.

S307: The second communication apparatus reorders the second SC-LDPC codeword to obtain the first SC-LDPC codeword.

The process shown in S307 is the reverse process of S303.

It can be understood that the first communication apparatus may indicate, to the second communication apparatus, the arrangement manner of obtaining the second SC-LDPC codeword from the first SC-LDPC codeword. This enables the second communication apparatus to restore the first SC-LDPC codeword based on the indicated arrangement manner after obtaining the second SC-LDPC codeword.

As for the description of the first SC-LDPC codeword, refer to the related descriptions in the preceding content. Details are not described herein again.

In a possible implementation, the second communication apparatus may use the first row-column interleaver to perform de-interleaving processing on the second SC-LDPC codeword, to obtain the first SC-LDPC codeword. The number of rows of the first row-column interleaver is Q, and the number of columns is (A+B).

In another possible implementation, the second communication apparatus may, based on a decoding manner of the first SC-LDPC codeword, reorder the Q groups of information bits and the Q groups of check bits included in the second SC-LDPC codeword, to obtain the first SC-LDPC codeword.

S308: The second communication apparatus decodes the first SC-LDPC codeword based on the check matrix of the target SC-LDPC code, to obtain the information bits.

Optionally, after S308, the method 300 further includes S309: The second communication apparatus obtains the check matrix of the target SC-LDPC code, and decodes the first SC-LDPC codeword based on the check matrix of the target SC-LDPC code.

Wherein, the process by which the second communication apparatus obtains the check matrix of the target SC-LDPC code may refer to the relevant descriptions in S301 in the foregoing content, and is not described herein again. It should be noted that the target code rate and the length of the information bits that are used by the second communication apparatus to obtain the check matrix of the target SC-LDPC code may be indicated by the first communication apparatus to the second communication apparatus.

In the embodiments of this application, the first communication apparatus (for example, an encoding apparatus) encodes information bits by using the check matrix of the obtained target SC-LDPC code, thereby obtaining the first SC-LDPC codeword. The decoding apparatus also uses the check matrix of the target SC-LDPC code to decode the first SC-LDPC codeword. Since the first communication apparatus and the decoding apparatus obtain the sub-parity matrices of the check matrix of the target SC-LDPC code, and these sub-parity matrices have a coupling characteristic, therefore, better bit error performance can be obtained. In addition, the check matrix of the target SC-LDPC code increases the parallelism of decoding, which can achieve fast decoding and obtain better decoding performance.

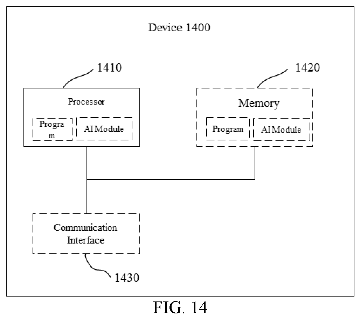

The preceding text has provided a detailed description of the method provided in the embodiments of this application. The following text, in combination with FIG. 13 and FIG. 14, provides a detailed description of the apparatus provided in the embodiments of this application.

FIG. 13 and FIG. 14 are schematic diagrams of possible apparatuses according to embodiments of this application. These apparatuses may be used to implement functions of the first communication apparatus or the second communication apparatus in the foregoing method embodiments. Therefore, these apparatuses can also implement beneficial effects of the foregoing method embodiments.

Figure 13 is a schematic block diagram illustrating an apparatus according to an embodiment of this application. As shown in Figure 13, the apparatus 1300 includes a processing module 1310. Optionally, the apparatus 1300 may further include a transceiver module 1320.

An optional design is that the apparatus 1300 is configured to implement the functions of the first communication apparatus in the method embodiment shown in FIG. 3 in the foregoing method embodiment.

For example, the processing module 1310 is configured to: obtain a check matrix of a target SC-LDPC code, where the check matrix of the target SC-LDPC code is obtained from a preset check matrix of an SC-LDPC code based on the target code rate and the length of the information bits; and based on the check matrix of the target SC-LDPC code, encode the information bits to obtain a first SC-LDPC codeword.

Optionally, the processing module 1310 is further configured to: reorder the Q groups of encoded bits to obtain a second SC-LDPC codeword; and interleave and modulate the second SC-LDPC codeword to obtain a plurality of modulation symbols. The transceiver module 1320 is configured to: send the plurality of modulation symbols.

Optionally, the processing module 1310 is further configured to: perform interleaving processing on the first SC-LDPC codeword by using a first row-column interleaver, to obtain the second SC-LDPC codeword, wherein the first row-column interleaver has Q rows and (A+B) columns.

Optionally, the processing module 1310 is further configured to: based on a decoding manner of the first SC-LDPC codeword, reorder the Q groups of encoded bits, to obtain the second SC-LDPC codeword.

For more detailed descriptions of the transceiver module 1310 and the processing module 1320, direct reference can be made to the descriptions related to the embodiment shown in FIG. 3 to obtain the detailed descriptions directly. Here, no further elaboration will be provided.

Another possible design is that the apparatus 1300 is configured to implement the functions of the second communication apparatus in the method embodiment shown in FIG. 3.

For example, the transceiver module 1320 is configured to: receive a plurality of modulation symbols; and the processing module 1310 is configured to: demodulate and process the plurality of modulation symbols, to obtain a first SC-LDPC codeword; obtain a check matrix of a target SC-LDPC code, wherein the check matrix of the target SC-LDPC code is obtained from a preset check matrix of an SC-LDPC code based on a target code rate and a length of an information bit; and

Optionally, the processing module 1310 is further configured to: perform demodulation on the plurality of modulation symbols to obtain a third SC-LDPC codeword, wherein the third SC-LDPC codeword includes (Q*A) information bits and (Q*B) check bits; and perform de-interleaving processing on the third SC-LDPC codeword to obtain a second SC-LDPC codeword, wherein the second SC-LDPC codeword includes Q groups of information bits and Q groups of check bits, wherein Q=N/n.

Optionally, the processing module 1310 is further configured to: use the first row-column interleaver to perform de-interleaving processing on the second SC-LDPC codeword to obtain the first SC-LDPC codeword, wherein the number of rows of the first row-column interleaver is Q, and the number of columns is (A+B).

Optionally, the processing module 1310 is further configured to: based on a decoding manner of the first SC-LDPC codeword, reorder the Q groups of information bits and the Q groups of check bits, to obtain the first SC-LDPC codeword.

For a more detailed description of the aforementioned transceiver module 1310 and processing module 1320, one can directly refer to the relevant descriptions in the embodiment shown in Figure 3. This will provide the necessary details, and thus, further elaboration here is unnecessary.

It should be noted that the apparatus 1300 may include a sending module but not a receiving module. Alternatively, the apparatus 1300 may include a receiving module but not a sending module. Specifically, this can depend on whether the sending action and receiving action are included in the above-mentioned scheme executed by the apparatus 1300. It can be understood that, since the apparatus 1300 has communication functionality, it can also be referred to as a communication apparatus.

Figure 14 is another schematic block diagram of an apparatus provided in an embodiment of this application. As shown in Figure 14, the apparatus 1400 includes one or more processors 1410. The processor 1410 may be a general-purpose processor, a dedicated processor, or the like. For example, it may be a baseband processor or a central processing unit. The baseband processor may be configured to process a communication protocol and communication data. The central processing unit may be configured to control the apparatus (for example, the first communication apparatus, the second communication apparatus, or a chip) to execute a software program and process data of the software program.

Optionally, in a design, the processor 1410 may include a program (which may also be referred to as code or instructions)). The program may be run on the processor 1410, so that the apparatus 1400 performs the method performed by the first communication apparatus or the second communication apparatus in the method embodiment described above. In another possible design, the apparatus 1400 may include a circuit (not shown in FIG. 14)), and the circuit is configured to implement the functions of the first communication apparatus or the second communication apparatus in the method embodiment described above.

For example, the processor 1410 may be configured to execute the computer program or instructions stored in the memory, so as to implement the steps performed by the first communication apparatus or the second communication apparatus in the method embodiment shown in FIG. 3 in any one of the embodiments shown in the method embodiment.

Optionally, the apparatus 1400 may include one or more memories 1420, and the memories 1420 store a program (which may also be referred to as code or instructions)). The program may be run on the processor 1410, so that the apparatus 1400 performs the method performed by the first communication apparatus or the second communication apparatus in the method embodiment described above.

Optionally, the processor 1410 and/or the memory 1420 may further include an artificial intelligence (artificial intelligence, AI) module. The AI module is configured to implement AI-related functions. The AI module may be implemented through software, hardware, or a combination of software and hardware. For example, the AI module may include a radio intelligent controller (radio intelligent controller, RIC) module. For example, the AI module may be a near real-time RIC or a non-real-time RIC.

Optionally, the processor 1410 and/or the memory 1420 may further store data. The processor and the memory may be separately disposed, or may be integrated together.

Optionally, the apparatus 1400 may further include a communications interface 1430. The processor 1410 may sometimes also be referred to as a processing unit, and is configured to control the apparatus (for example, the first communication apparatus or the second communication apparatus)).

Optionally, the apparatus 1400 further includes a communications interface 1430. The processor 1410 and the communications interface 1430 are coupled to each other. It may be understood that the communications interface 1430 may be a transceiver or an input/output interface.

It may be understood that the apparatus 1400 has a communication function, and therefore may also be referred to as a communication apparatus.

When the apparatus 1400 is configured to implement the method in FIG. 3, the processor 1410 is configured to perform a function of the foregoing processing unit, and the communications interface 1430 is configured to perform a function of the foregoing transceiver module. The communications interface 1430 is used to send or receive, and may specifically depend on whether the communications interface 1430 is used to perform a sending action or a receiving action in the solution executed by the apparatus 1400.

When the apparatus 1400 is a chip applied to the first communication apparatus, the chip implements a function of the first communication apparatus in the method embodiment. The chip of the first communication apparatus receives a signal from another module (such as a radio frequency module or an antenna) in the first communication apparatus, and the signal may be sent by the second communication apparatus to the first communication apparatus. Alternatively, the chip of the first communication apparatus sends a signal to another module (such as a radio frequency module or an antenna) in the first communication apparatus, where the signal may be sent by the first communication apparatus to the second communication apparatus.

When the aforementioned apparatus 1400 is a chip applied to a second communication apparatus, the chip implements the functions of the second communication apparatus as described in the method embodiments. The chip of the second communication apparatus may receive a signal from another module (such as a radio frequency module or an antenna) within the second communication apparatus. The signal may be sent by the first communication apparatus to the second communication apparatus. Alternatively, the chip of the second communication apparatus may send a signal to another module (such as a radio frequency module or an antenna) within the second communication apparatus. The signal may be sent by the second communication apparatus to the first communication apparatus.

It can be understood that, when the apparatus 1400 is a chip applied to a first communication apparatus or a second communication apparatus, the communications interface 1430 may be a transceiver, and may specifically include a transmitter and a receiver. The transmitter is configured to send a signal, and the receiver is configured to receive a signal. When the apparatus 1400 is a chip applied to a first communication apparatus or a second communication apparatus, the communications interface 1430 may be an input/output circuit, where the input circuit may be configured to receive, and the output interface may be configured to send.

It should be noted that the foregoing method embodiments may be applied to a processor or may be implemented by the processor. The processor may be an integrated circuit chip and has a signal processing capability. In an implementation process, the steps of the foregoing method embodiments may be implemented by using an integrated logic circuit in hardware in the processor, or by using instructions in a form of software.

The processor mentioned above may be a general-purpose processor, a digital signal processor (digital signal processor, DSP), an application-specific integrated circuit (application specific integrated circuit, ASIC), a field programmable gate array (field programmable gate array, FPGA), or another programmable logic device, a discrete gate, or a transistor logic device, a discrete hardware component, or any combination thereof. The general-purpose processor may be a microprocessor, or may be any conventional processor and the like.

The steps of the method disclosed with reference to the embodiments of this application may be directly performed and completed by a hardware decoding processor, or may be performed and completed by using a combination of hardware and software modules in the decoding processor. The software module may be located in a mature storage medium in the art, such as a random access memory, a flash memory, a read-only memory, a programmable read-only memory, an electrically erasable programmable memory, or a register. The storage medium is located in the memory, and the processor reads information in the memory, and completes the steps of the foregoing method in combination with hardware of the processor.

The memory in the embodiments of this application may be a volatile memory or a non-volatile memory, or may include both a volatile memory and a non-volatile memory. The nonvolatile memory may be a read-only memory (read-only memory, ROM), a programmable read-only memory (programmable ROM, PROM), an erasable programmable read-only memory (erasable PROM), EPROM), electrically erasable programmable read-only memory (EPROM), or flash memory. The volatile memory may be a random access memory (random access memory, RAM) used as an external cache. By way of example, but not limitation, many forms of RAM are available, such as static random access memory (SRAM), dynamic random access memory (DRAM), synchronous dynamic random access memory (DRAM), SDRAM), double data rate synchronous dynamic random access memory (DDR SDRAM), enhanced synchronous dynamic random access memory (ESDRAM), synchronously connected dynamic random access memory (synchlink DRAM, SLDRAM) and direct rambus random access memory (DR RAM). It should be noted that the memory for the systems and methods described herein is intended to include, but are not limited to, these and any other suitable types of memory.

This application further provides an computer-readable medium, where a computer program is stored in the computer-readable medium. When the computer program is executed by a computer, functions of the foregoing method embodiment are implemented.

This application further provides a computer program product that includes an instruction. When the computer program product is executed by a computer, functions of the foregoing method embodiments are implemented.

All or some of the methods provided in the foregoing embodiments may be implemented by using software, hardware, firmware, or any combination thereof. When implemented by using software, all or some of the applications may be implemented in a form of a computer program product. The computer program product may include one or more computer instructions. When the computer program instructions are loaded and executed on a computer, all or some of the procedures or functions according to the embodiments of this application are generated. The computer may be a general-purpose computer, a dedicated computer, a computer network, or another programmable apparatus. The computer instructions may be stored in a computer-readable storage medium, or transmitted from one computer-readable storage medium to another computer-readable storage medium, for example, the computer instructions may be wired from a website site, computer, server, or data center (e.g. Coaxial Cable, Fiber Optic, Digital Subscriber Line (DSL)) or wireless (e.g., infrared, wireless, microwave) transmission to another website site, computer, server, or data center. The computer-readable storage medium may be any usable medium accessible by a computer, or a data storage device such as a server or a data center that integrates one or more usable media. The usable medium may be a magnetic medium (for example, a floppy disk, a hard disk, or a magnetic disk), an optical medium (for example, a DVD), a semiconductor medium (for example, a solid state disk solid state disk (SSD)), or the like.

A person of ordinary skill in the art may be aware that units and algorithm steps in the examples described with reference to the embodiments disclosed in this specification can be implemented by electronic hardware, or a combination of computer software and electronic hardware. Whether these functions are executed in a hardware or software manner depends on a specific application and a design constraint condition of the technical solution. A person skilled in the art may implement the described functions by using different methods for each specific application. However, it should not be considered that the implementation goes beyond the scope of this application.

It may be clearly understood by a person skilled in the art that, for the purpose of convenient and brief description, for a specific working process of the foregoing system, apparatus, and unit, refer to a corresponding process in the foregoing method embodiments. Details are not described herein again.

In the several embodiments provided in this application, it should be understood that the disclosed system, apparatus, and method may be implemented in other manners. For example, the described apparatus embodiment is merely exemplary. For example, the unit division is merely logical function division, and may be other division in actual implementation. For example, a plurality of units or components may be combined or integrated into another system, or some features may be ignored. Or not perform. In addition, the displayed or discussed mutual couplings or direct couplings or communication connections may be implemented by using some interfaces, and the indirect couplings or communication connections between apparatuses or units may be implemented in electrical, mechanical, or other forms.

The units described as separate components may or may not be physically separate. The components displayed as units may or may not be physically separate units. That is, they may be located in one place, or they may be distributed over multiple network units. According to actual needs, some or all of the units may be selected to achieve the objectives of the solutions in the embodiments of this application.

Additionally, in the various embodiments of this application, the functional units may be integrated into one processing unit, or each unit may exist physically and independently. Alternatively, two or more units may be integrated into one unit.

If the functions are implemented in the form of software functional units and sold or used as independent products, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, or a network device) to perform all or some of the steps of the methods described in the embodiments of this application. The foregoing storage medium includes: various media that can store program code, such as a USB flash drive, a removable hard disk, a read-only memory, a random access memory, a magnetic disk, or an optical disc.

As described above, this is merely a specific implementation of this application. However, the protection scope of this application is not limited thereto. Any person skilled in the art of this technology, within the technical scope disclosed by this application, can easily think of variations or replacements, all of which should be covered within the protection scope of this application. Therefore, the protection scope of this application shall be determined according to the protection scope of the claims described above.

## Claims

1. A communication method, comprising:
obtain a check matrix of a target space-coupled low-density parity check SC-LDPC code, wherein the check matrix of the target SC-LDPC code is obtained from the check matrix of a preset SC-LDPC code based on a target code rate and a length of information bits; the number of rows of the check matrix of the preset SC-LDPC code is M, and the number of columns of the check matrix of the preset SC-LDPC code is N, wherein the value of the elements in the check matrix of the preset SC-LDPC code is 0 or 1, or, the number of rows of the check matrix of the target SC-LDPC code is M, the number of columns of the check matrix of the target SC-LDPC code is N, and the value of the elements in the check matrix of the target SC-LDPC code is 0 or 1;
wherein the first matrix that includes a 0th row to a (M-1)th row in the M rows and a 0th column to a (n-1)th column in the N columns includes a second matrix whose quantity of rows is ((Z+1)*m) and whose quantity of columns is n, elements in the jth column to the (j+n-1)th column in the N columns are obtained by cyclically shifting ((j/n)*m) rows downwards in the first matrix, and the second matrix is a matrix formed by an ith row to an (i+(Z+1)*m-1)th row in the first matrix, and all other elements in the first matrix except the second matrix are 0, and the second matrix is obtained by arranging (Z+1) third matrices whose rows are m and whose columns are n in sequence according to rows, and Z third matrices exist in the (Z+1) third matrices, a quantity of elements 1 comprised in the Z third matrices K and a quantity of elements 1 comprised in the second matrix L satisfy the following relationship: K/L=Z*z%, (L-K) ≥ (K/Z), or a quantity of remaining elements 1 in the second matrix except the K elements 1 included in the Z third matrices is greater than or equal to a quantity of elements 1 included in at least one of the Z third matrices; and; Z is an integer greater than 0, z is an integer less than or equal to 100*R, or z is an integer less than or equal to 100*(1-R), R is the target code rate or a maximum code rate or a minimum code rate supported by the preset check matrix of the SC-LDPC code, i is an integer greater than or equal to 0 and less than or equal to (M - (Z+1)*m), and j=n; and 2*n, ..., y*n; (y+1)=N/n, M can be divisible by m, and n, m, and y are integers greater than 1;
encoding the information bits based on the check matrix of the target SC-LDPC code, to obtain a first SC-LDPC codeword.

2. The method according to claim 1, wherein K elements 1 comprised in a fourth matrix are evenly distributed in L elements 1 comprised in a fifth matrix, and the fourth matrix is a sum of the Z third matrices; and the fifth matrix is a sum of the (Z+1) third matrices.

3. The method according to claim 2, wherein the element 1 comprised in each of the Z third matrices is evenly distributed in the K elements 1 comprised in the fourth matrix.

4. The method according to any one of claims 1 to 3, wherein the first SC-LDPC codeword comprises Q groups of coded bits, and each group of coded bits in the Q groups of coded bits comprises a group of information bits and a group of check bits; and Each group of information bits in the Q groups of information bits includes A information bits, each group of check bits in the Q groups of check bits includes B check bits, A and B are integers greater than 0, and Q=N/n.

5. The method according to claim 4, wherein the method further comprises:
reordering the Q groups of coded bits to obtain a second SC-LDPC codeword, wherein the Q groups of information bits and the Q groups of check bits that are comprised in the second SC-LDPC codeword meet any one of the following characteristics:
the Q groups of information bits are located before the Q groups of check bits;
q groups of coded bits that are used as a decoding start point in the Q groups of coded bits are located before other groups of coded bits;
q groups of coded bits that are used as a decoding start point in the Q groups of coded bits are located before other groups of coded bits, and an information bit in each group of coded bits is located before a check bit; or,
q groups of coded bits in the Q groups of coded bits that are used as a decoding start point are located before another group of coded bits, information bits in the q groups of coded bits are located before check bits in the q groups of coded bits, and q is an integer greater than 0 and less than or equal to Q;
interleave and modulate the second SC-LDPC codeword to obtain multiple modulation symbols; and;
sending the plurality of modulation symbols.

6. The method according to claim 5, wherein locations of the other groups of coded bits in the second SC-LDPC codeword are arranged in ascending order of a first distance, and the first distance is a quantity of coded bit groups between each of the other groups of coded bits and the q groups of coded bits in the first SC-LDPC codeword.

7. The method according to claim 5, wherein the information bits in the other groups of coded bits are located before the check bits in the other groups of coded bits.

8. The method according to any one of claims 5 to 7, wherein the reordering the Q groups of encoded bits to obtain a second SC-LDPC codeword comprises:
performing interleaving processing on the first SC-LDPC codeword by using a first row-column interleaver, to obtain the second SC-LDPC codeword, wherein the first row-column interleaver has Q rows and (A+B) columns.

9. The method according to any one of claims 5 to 7, wherein the reordering the Q groups of encoded bits to obtain a second SC-LDPC codeword comprises:
reordering the Q groups of encoded bits to obtain the second SC-LDPC codeword, based on a decoding method of the first SC-LDPC codeword, to obtain the second SC-LDPC codeword.

10. The method according to claim 9, wherein the decoding method is bidirectional sliding window decoding, and the q groups of encoded bits are the first group of encoded bits and the Qth group of encoded bits in the first SC-LDPC codeword.

11. The method according to claim 9, wherein the decoding manner is parallel sliding window decoding, q is an integer greater than 2 and less than or equal to Q, and the q groups of encoded bits are the groups of encoded bits that serve as the starting point for decoding in the Q groups of encoded bits.

12. A communication method, comprising:
receiving multiple modulated symbols;
demodulating and processing the plurality of modulated symbols to obtain a first SC-LDPC codeword;
obtaining the check matrix of the target SC-LDPC code, wherein the check matrix of the target SC-LDPC code is obtained from the check matrix of the preset SC-LDPC code based on the target code rate and the length of information bits; wherein the number of rows of the check matrix of the preset SC-LDPC code is M, the number of columns of the check matrix of the preset SC-LDPC code is N, the value of the elements in the check matrix of the preset SC-LDPC code is 0 or 1, or, the number of rows of the check matrix of the target SC-LDPC code is M, the number of columns of the check matrix of the target SC-LDPC code is N, and the value of the elements in the check matrix of the target SC-LDPC code is 0 or 1;
wherein the first matrix that includes a 0th row to a (M-1)th row in the M rows and a 0th column to a (n-1)th column in the N columns includes a second matrix whose quantity of rows is ((Z+1)*m) and whose quantity of columns is n. elements in the jth column to the (j+n-1)th column in the N columns are obtained by cyclically shifting ((j/n)*m) rows downwards in the first matrix, and the second matrix is a matrix formed by an ith row to an (i+(Z+1)*m-1)th row in the first matrix, and all other elements in the first matrix except the second matrix are 0; and the second matrix is obtained by arranging (Z+1) third matrices whose rows are m and whose columns are n in sequence according to rows, and Z third matrices exist in the (Z+1) third matrices, a quantity of elements 1 comprised in the Z third matrices K and a quantity of elements 1 comprised in the second matrix L satisfy the following relationship: K/L=Z*z%, (L-K) ≥ (K/Z), or a quantity of remaining elements 1 in the second matrix except the K elements 1 included in the Z third matrices is greater than or equal to a quantity of elements 1 included in at least one of the Z third matrices; and; Z is an integer greater than 0, z is an integer less than or equal to 100*R, or z is an integer less than or equal to 100*(1-R), R is the target code rate or a maximum code rate or a minimum code rate supported by the preset check matrix of the SC-LDPC code, i is an integer greater than or equal to 0 and less than or equal to (M - (Z+1)*m), and j=n; and 2*n, ..., y*n; (y+1)=N/n, M can be divisible by m, and n, m, and y are integers greater than 1;
decoding the first SC-LDPC codeword based on the check matrix of the target SC-LDPC code, to obtain the information bits.

13. The method according to claim 12, wherein K elements 1 comprised in a fourth matrix are evenly distributed in L elements 1 comprised in a fifth matrix, and the fourth matrix is a sum of the Z third matrices; and the fifth matrix is a sum of the (Z+1) third matrices.

14. The method according to claim 13, wherein the element 1 comprised in each of the Z third matrices is evenly distributed in the K elements 1 comprised in the fourth matrix.

15. The method according to any one of claims 12 to 14, wherein the first SC-LDPC codeword comprises Q groups of coded bits, and each group of coded bits in the Q groups of coded bits comprises a group of information bits and a group of check bits; and Each group of information bits in the Q groups of information bits includes A information bits, each group of check bits in the Q groups of check bits includes B check bits, A and B are integers greater than 0, and Q=N/n.

16. The method according to claim 15, wherein the demodulating and processing the multiple modulation symbols to obtain a first SC-LDPC codeword comprises:
demodulating the multiple modulation symbols to obtain a third SC-LDPC codeword, wherein the third SC-LDPC codeword comprises (Q*A) information bits and (Q*B) check bits; and;
performing de-interleaving processing on the third SC-LDPC codeword to obtain the second SC-LDPC codeword, wherein the second SC-LDPC codeword comprises Q groups of information bits and Q groups of check bits; and;
reordering Q groups of information bits and Q groups of check bits in the second SC-LDPC codeword, to obtain the first SC-LDPC codeword.

17. The method according to claim 16, wherein the Q groups of information bits and the Q groups of check bits in the second SC-LDPC codeword meet any one of the following characteristics:
the Q groups of information bits are located before the Q groups of check bits;
q groups of coded bits that are used as the decoding start point in the Q groups of coded bits are located before other groups of coded bits;
q groups of coded bits in the Q groups of coded bits that are used as a decoding start point are located before other groups of coded bits, and an information bit in each group of coded bits is located before a check bit; or,
q groups of coded bits in the Q groups of coded bits that are used as a decoding start point are located before another group of coded bits, and an information bit in the q groups of coded bits is located before a check bit in the q groups of coded bits.

18. The method according to claim 17, wherein locations of the other groups of coded bits in the second SC-LDPC codeword are arranged in ascending order of a first distance, and the first distance is a quantity of coded bit groups between each of the other groups of coded bits and the q groups of coded bits in the first SC-LDPC codeword.

19. The method according to claim 17, wherein the information bits in the other groups of coded bits are located before the check bits in the other groups of coded bits.

20. The method according to any one of claims 16 to 19, wherein the reordering Q groups of information bits and Q groups of check bits in the second SC-LDPC codeword, to obtain the first SC-LDPC codeword comprises:
performing de-interleaving processing on the second SC-LDPC codeword by using a first row-column interleaver, to obtain the first SC-LDPC codeword, wherein a quantity of rows of the first row-column interleaver is Q, and a quantity of columns of the first row-column interleaver is (A+B).

21. The method according to any one of claims 16 to 19, wherein the reordering Q groups of information bits and Q groups of check bits in the second SC-LDPC codeword, to obtain the first SC-LDPC codeword comprises:
reordering the Q groups of information bits and the Q groups of check bits based on a decoding mode for the first SC-LDPC codeword, to obtain the first SC-LDPC codeword.

22. A communication apparatus, comprising a module configured to implement the method according to any one of claims 1 to 11; or comprising a module configured to implement the method according to any one of claims 12 to 21.

23. A communication apparatus, comprising a processor, configured to: execute a computer program, and/or enable the communication apparatus to implement the method according to any one of claims 1 to 11 by using a logic circuit, wherein or enable the communication apparatus to implement the method according to any one of claims 12 to 21.

24. The apparatus according to claim 23, further comprising a memory, configured to store a computer program and/or a configuration file of the logic circuit.

25. The apparatus according to claim 23 or 24, further comprising a communications interface, configured to input and/or output a signal.

26. A computer readable storage medium, wherein the computer readable storage medium stores a computer program, and when the computer program is executed by a processor, the method according to any one of claims 1 to 11 is performed; and or the method according to any one of claims 12 to 21 is performed.

27. A computer program product, comprising a computer program, wherein when the computer program is run, the method according to any one of claims 1 to 11 is performed, or the method according to any one of claims 12 to 21 is performed.

28. A communication system, comprising a first communication apparatus and a second communication apparatus, wherein the first communication apparatus is configured to implement the method according to any one of claims 1 to 11, and the second communication apparatus is configured to implement the method according to any one of claims 12 to 21.
